# EUROPÄISCHE PATENTSCHRIFT

(11) **EP 3 099 462 B1**
(45) Veröffentlichungstag und Bekanntmachung des Hinweises auf die Patenterteilung: **09.08.2017**
(21) Anmeldenummer: 15702420.9
(22) Anmeldetag: 23.01.2015
(51) Int. Cl.: B29C 41/32, C08J 3/24, C08J 7/04

(54) **VERFAHREN ZUR HERSTELLUNG VON SILICONMEHRSCHICHTVERBUNDEN**
METHOD FOR PRODUCING SILICON MULTI-LAYER COMPOSITES
PROCÉDÉ DE FABRICATION DE COMPOSITES MULTICOUCHES EN SILICONE

(30) Priorität: 30.01.2014 DE 102014201689
(43) Veröffentlichungstag der Anmeldung: 07.12.2016
(73) Patentinhaber: Wacker Chemie AG, 81737 München (DE)
(72) Erfinder: KOELLNBERGER, Andreas, 84375 Kirchdorf (DE); SCHWINGHAMMER, Alfred, 84347 Pfarrkirchen (DE)
(74) Vertreter: Mieskes, Klaus Theoderich
(86) Internationale Anmeldenummer: PCT/EP2015/051404
(87) Internationale Veröffentlichungsnummer: WO 2015/113911

(56) Entgegenhaltungen:
- WO-A1-2007/081205
- DE-A1- 2 045 558

## Beschreibung

Die vorliegende Erfindung betrifft die kontinuierliche Herstellung von Mehrschichtverbunden, welche aus mindestens zwei Schichten Siliconelastomer bestehen, wobei die Dicke der einzelnen Schichten zwischen 0,1 und 200 µm liegt und die Dickengenauigkeit ±5 % gemessen auf einer Fläche von 200 cm² beträgt, sowie die nach diesem Verfahren hergestellten Siliconfolien und deren Verwendung.

EP1971720B1 beschreibt die Herstellung von Mehrschichtverbunden auf einem Träger, wobei mindestens zwei Schichten aufgetragen werden, bevor eine Vernetzung stattfindet. Das beschriebene Verfahren hat den Nachteil, dass die geforderten Dickengenauigkeiten der Einzelschichten nicht erreicht werden.

In EP0781198B1 werden Mehrschichtklebeaufbauten beschrieben, welche neben dem Schichtmaterial eine Barriereschicht sowie eine Klebeschicht enthalten, um die Wanderung des in der Klebeschicht enthaltenen migrationsfähigen Additivs zu minimieren. Auch dieses Verfahren ermöglicht nicht die gewünschte Schichtdicke bei gleichzeitiger Dickengenauigkeit herzustellen.

EP0097313A1 beschreibt die Herstellung eines dünnen Siliconelastomerfilms, der zwischen einem und 500 µm dick ist und der bei der Herstellung auf ein beschichtetes Papier aufgebracht wird. Hierzu werden die Beschichtungstechniken Rollenbeschichtung, Luftrakel oder Reverse Roll coating, Wirewound bar coating oder Sprüh coating zur Herstellung dünner Folien verwendet. Diese Techniken ergeben Folien, die nicht die geforderten Dickengenauigkeiten aufweisen.

In DE2408659 wird ein Verfahren zur Herstellung dünner, fehlerfreier Siliconfolien beschrieben, wobei der Siliconfilm durch gießen einer zentrifugierten, mit Lösungsmittel versehenen Siliconmasse hergestellt wird. Das aufwändige Verfahren ist jedoch zur industriellen Herstellung in einem kontinuierlichen Prozess nicht geeignet. Zudem werden durch Gießprozesse die geforderten Dickengenauigkeiten ebenfalls nicht erreicht.

Wie der Stand der Technik zeigt, können Siliconfolien in einem Dickenbereich ab etwa 200 µm bis zu mehreren mm durch Extrusions- oder Moldingverfahren hergestellt werden. Dabei zeigen die jeweiligen Verfahren unterschiedliche Nachteile. Bei diskontinuierlichen Moldingverfahren geht eine Verminderung der Schichtdicke mit Problemen beim automatischen Entformen einher, zudem sind die Produktionskosten je Quadratmeter (qm) Folie höher als bei kontinuierlich arbeitenden Prozessen. Extrusionsverfahren von HTV-Kautschuken haben den Nachteil größerer Dickenvarianzen sowie die durch Anlagenauslegung und Schlitzquellung begrenzte Möglichkeit der Schichtdickenverringerung unter 200 µm Schichtdicke.

Neben der absoluten Schichtdicke spielt die Gleichmäßigkeit der Schichtdicke über die gesamte produzierte Bahn eine entscheidende Rolle für Anwendungen der Verbunde z.B. in optischen, elektrischen, oder medizinischen Bereichen.

Derartiger Verbunde mit Dicken der jeweiligen Silicon-Einzelschicht zwischen einem und ca. 250 µm können vor allem im Bereich dielektrischer, elektroaktiver Polymere (kurz EAP)liegen, bei denen die Siliconschicht als Dielektrikum in einem flexiblen, kondensatorartigen Aufbau verwendet wird. Ihre Anwendungen in Aktoren, Sensoren oder Generatoren basieren darauf, elektrische in mechanische Energie oder mechanische in elektrische Energie zu wandeln. Solche Verbunde haben zudem hohe Anforderungen an ihre mechanischen Eigenschaften, um die Wartungskosten möglichst gering zu halten, da sie einer fortwährenden mechanischen Belastung ausgesetzt sind.

Aufgabe war daher die Bereitstellung eines kontinuierlichen Verfahrens zur Herstellung dünner Siliconmehrschichtverbunde, mit sehr dünner und sehr gleichmäßigen Siliconschichtdicken, sowie mit hoher Oberflächengüte und hoher Dauerbelastungsbeständigkeit und guten oder verbesserten mechanischen Eigenschaften in Bezug auf den Gesamtverbund.

Überraschenderweise wird diese Aufgabe gelöst vom erfindungsgemäßen Verfahren zur Herstellung von Silicon-Mehrschichtverbunden, bei denen mindestens zwei Schichten aus gehärtetem Silicon mit jeweils einer Schichtdicke von 0,1 bis 200 µm, und einer Dickengenauigkeit der Siliconschichten von ±5 % gemessen auf einer Fläche von 200 cm² bestehen,
dadurch gekennzeichnet, dass
i) eine lösungsmittelhaltige oder lösungsmittelfreie, vernetzbare Siliconzusammensetzung (X) durch den Spalt einer Schlitzdüse auf einen sich bewegenden Träger aufgetragen wird,
ii) anschließend aus der Siliconschicht, welche sich auf der Trägerfolie ausbildet das Lösungsmittel, falls vorhanden, entfernt und die Siliconschicht teilweise vernetzt wird, so dass sie einen Vernetzungsgrad von mindestens 40% und höchstens 90% aufweist,
iii) gegebenenfalls Zwischenschichten aufgetragen werden, so dass ein 1ter Schichtverbund, aus Träger, einer vernetzten Siliconschicht sowie gegebenenfalls Zwischenschichten entsteht,
iv) eine lösungsmittelhaltige oder lösungsmittelfreie, vernetzbare Siliconzusammensetzung (X) durch den Spalt einer Schlitzdüse auf den sich bewegenden 1ten Schichtverbund aufgetragen wird,
v) anschließend aus der Siliconschicht, welche sich auf dem 1ten Schichtverbund ausbildet das Lösungsmittel, falls vorhanden, entfernt und die Siliconschicht teilweise vernetzt wird, so dass sie einen Vernetzungsgrad von mindestens 40% und höchstens 90% aufweist,
vi) gegebenenfalls die Schritte iii) bis v) noch mindestens 1 mal wiederholt werden,
vii) eine finale Vernetzung der Siliconschichten erfolgt, da in den Schritten ii) und v) nur eine Teilvernetzung stattfand,
viii) anschließend der entstandene Silicon-Mehrschichtverbund vom Träger getrennt werden kann,
mit folgenden Maßgaben:
- die Schlitzdüse in Schritt i) und iv) steht in einem Winkel zwischen 10° und 90° zum Träger;
- die Laufgeschwindigkeit des Trägers bzw. des 1ten sowie weiteren Schichtverbunde in den Schritten i) sowie iv) liegt zwischen 0,1 und 1000m/min;
- die dynamische Viskosität bei 25°C gemessen nach DIN 53019 der Siliconzusammensetzung (X) liegt zwischen 100mPa●s und 1000Pa●s,
- die Oberfläche des Trägers enthalten keine Vertiefungen oder Erhebungen, die größer als 5% der herzustellenden Foliendicken sind, und
- Partikel die größer als 1/3 der einzelnen Siliconschichtdicke sind, aus der vernetzbaren Siliconzusammensetzung (X) vor ihrer Verwendung entfernt werden.

Die Messung der Schichtdicke als auch der Oberflächengüte kann sowohl direkt bei der Herstellung (in-line) als auch anschließend (off-line) erfolgen. Geeignete Methoden sind kommerziell verfügbare Messungen wie zum Beispiel optische Methoden wie die Konfokal- oder die Rasterelektronenmikroskopie, Triangulationsverfahren, physikalische berührungslose und zerstörungsfreie Methoden wie Ultraschall-Absorbtionsmessung, Wirbelstromsensoren, Kapazitätssensoren, Durchstrahlung und Absorption von Röntgenstrahlung oder anderen Arten von Strahlung.

Wenn die absolute Schichtdicke mit Hilfe einer REM-Analyse (Rasterelektronenmikroskop-Analyse) bestimmt wird, wird dies mit einem Kryoschnitts durchgeführt. Die Oberflächengüte und Rauhigkeit werden beispielsweise mit Hilfe eines Konfokal-Mikroskops ermittelt. Bei der Herstellung der einzelnen Schichten kann zudem ein Bahnprotokoll bei jeder einzelnen Schicht aufgezeichnet werden, so dass jeder Messwert der Schichtdicke eines definierten Punktes (bestimmt gemäß der x- und y-Achse der Bahn) elektronisch gespeichert wird.

Um Silicon-Mehrschichtverbunde zu erzeugen, die zudem eine verbesserte mechanische Gesamtstabilität haben, arbeitet man bevorzugt mit Teilvernetzung der Siliconschichten. Dazu werden die Vernetzungsbedingungen bei der Herstellung der einzelnen Schichten im Schritt ii) und v) so gewählt, dass das Silicon netzt, so dass es mindestens 40% seiner Endeigenschaften, insbesondere bezogen auf die Ausbildung der Netzpunkte, erreicht, also einen Vernetzungsgrad von mindestens 40% aufweist. Dadurch bleiben reaktive Gruppen auch an der Oberfläche der Siliconschicht, die anschließend mit den reaktiven Gruppen der nächsten Siliconschicht vernetzen und somit zu einer verbesserten Haftung zwischen den Siliconschichten beitragen. Die Bestimmung des Vernetzungsgrades erfolgt über geeigneten Messmethoden mittels einer materialspezifischen Kalibrierung über eine zuvor bestimmte Eichreihe. Diese Methode ist dem Fachmann bekannt. Bei additionsvernetzenden Zusammensetzungen wird der Vernetzungsgrad beispielsweise in einer direkten Messung mittels Infrarotspektroskopie durch Messung der nicht abreagierten Funktionalitäten Si-H- oder Si-Vinyl-Gruppen, bestimmt. Je nach verwendetem Material sind beispielsweise bei der Additionsvernetzung noch Si-H-Gruppen oder Si-Vinyl-Gruppen im vollständig vulkanisierten Material vorhanden. Bei nur teilweise vulkanisierten Proben liegen dagegen beide Funktionalitäten im Material vor. Aus diesem Grund ist eine materialspezifische Kalibrierung der Messanordnung über eine Eichreihe notwendig, welche an das jeweilige Material angepasst wird. Zur Infrarotdetektion der Si-H-Funktion kann beispielsweise die Bande bei 2160 cm⁻¹ verwendet werden, bei der Si-Vi-Funktion wird üblicherweise die Bande bei 3050 cm⁻¹ für die Messung herangezogen. Diese Messung kann sowohl innerhalb der Produktionslinie (in-line) als auch durch Probenahme und anschließende Bestimmung (off-line) erfolgen.

Für den Fall, dass kondensations-, peroxidisch, oder anderweitig vernetzende Siliconzusammensetzungen verwendet werden, kann die Infrarotmessung an die jeweils enthaltenen funktionellen Gruppen angepasst werden, welche für die Vernetzungsreaktion verantwortlich sind.

Indirekt kann der Vernetzungsgrad der Siliconschicht auch durch die Bestimmung der Härte (Penetration, Shore 00, Shore A oder Shore D) ermittelt werden. Auch hier wird in Abhängigkeit des verwendeten Materials mit der geeigneten Messmethode eine Eichreihe erstellt, mit deren Hilfe der gewünschte Vernetzungsgrad für die Siliconschichten eingestellt wird. Geeignete Methoden sind dem Fachmann bekannt unter Anderem aus DIN-, ASTM-, JIS und ISO-Vorschriften.

Die Vernetzungsbedingungen werden in den Schritt ii) und v) unabhängig voneinander bevorzugt so eingestellt, dass die Siliconschichten bevorzugt mindestens 50% und höchstens 80% und ganz besonders höchstens 70% Vernetzungsgrad aufweisen. Vor dem Aufbringen der zweiten Siliconschicht kann über den zusätzlichen Schritt iii) noch mindestens eine Zwischenschicht aufgetragen werden, die nicht auf Silicon basiert. Beispiele hierfür sind elektrisch oder thermisch leitende Bahnen oder Schichten, Metallfolien, Gewebe, Fasern, Barriereschichten, etc. welche mit verschiedenen Techniken, die dem Fachmann bekannt sind, auf die Siliconschicht aufgebracht werden können. Beispiele für solche Methoden sind: kaschieren, BeschichtungsTechniken wie drucken, sprühen, rakeln, Schlitzdüsen-Verfahren, Dispenstechniken, Chemical Vapor Deposition, Physical Vapor Deposition.

Darin liegt auch einer der großen Vorteile des hier beschriebenen Verfahrens, die eine automatisierte, großtechnische Herstellung von Stapelaufbauten auf der Basis dielektrischer Elastomere (DEA) ermöglicht. Nach Realisierung mindestens eines kondensatorartigen Aufbaus kann durch Anlegen von elektrischer Spannung eine Verformung des Gesamtsystems hervorgerufen werden (Prinzip des Aktors). Die mit dem beschriebenen Verfahren hergestellten Mehrschichtverbunde haben weiterhin den Vorteil, dass die Durchschlagsspannung der Siliconelastomerschicht gemessen nach ASTM D 3755 mindestens 25 kV/mm, bevorzugt mindestens 30 kV/mm und besonders bevorzugt mindestens 35 kV/mm und ganz besonders bevorzugt mindestens 40 kV/mm ist. Je nach Anwendung ist eine Vielzahl von Anordnungen oder Aufbauten aus den Mehrschichtverbunden denkbar, welche durch stapeln, falten, aufrollen, etc. erreicht werden können.

Weitere Anwendungen der mit dem beanspruchten Verfahren hergestellten erfindungsgemäßen Silicon-Mehrschichtverbunden sind: Barrierefolien im Medizin- oder Lebensmittelbereich, Isolierbänder, Schutzfolien (Tastaturen, Hautschutz, Mundschutz, Glas/Kratzschutz für diverse Materialie), Verpackungen aller Art (Lebensmittel, Pflanzen), Trägerfolien für Wundauflagen, Funktionsschichten in Kleidung, Stoff- oder Gastrennungsschicht (Gastrennung, Meerwasserentsalzung, ...), Trägerfolie, Koch- bzw. Garfolie, Folien für Display-Anwendungen, Airbags oder Weinkorken.

Überraschenderweise wurde gefunden, dass alle beschriebenen Nachteile, der aus dem Stand der Technik bekannten Prozesse, bei dem hier beschriebenen Verfahren unter Verwendung einer Schlitzdüse in Kombination mit einem planaren Träger nicht auftreten, und durch das beanspruchte Verfahren sehr präzise Mehrschichtverbunde auf Siliconbasis hergestellt werden können, die zudem durch Arbeiten mit Teilvernetzung der Siliconschichten eine Verbesserung der mechnischen Eigenschaften des finalen Silicon-Mehrschichtverbundes ermöglichen.

Die in dieser Schrift an unterschiedlichen Textstellen offenbarten bevorzugten Ausführungsformen einzelner Merkmale der vorliegenden Erfindung sind dahingehend zu verstehen, dass auch die Kombinationen dieser Merkmale in ihren bevorzugten Ausführungsformen besonders bevorzugt sind.

Das erfindungsgemäße Verfahren wird möglichst unter Partikelfreiheit durchgeführt. Partikelfreiheit bedeutet, dass beim Gesamtprozess der Schichtherstellung darauf geachtet werden muss, dass möglichst wenig Partikel, ob nun aus eventuell eingemischten aktiven oder inaktiven Füllstoffen, oder als Fremdpartikel, enthalten sind, welche größer sind, als etwa 1/3 der gewünschten Schichtdicke. Beispielsweise sind in einer 24 µm dicken, erfindungsgemäßen Siliconfolie vorzugsweise keine Partikel enthalten, deren Durchmesser 8µm übersteigt. Das Entfernen von eventuell enthaltenen Partikeln aus der Siliconzusammensetzung (X) kann prinzipiell durch alle Techniken erfolgen, die dem Stand der Technik bekannt sind. Beispiele hierfür sind Strainern über Strainersiebe (Drahtnetze, Drahtgeflecht), Filterkerzen aus den verschiedensten Materialien (Metall, Kunststoff, Keramik, etc.), Filtrationstechniken wie z.B. Magnetfiltration, Druckfiltration über Filterpressen, Rückspülfilter, Drucknutschen, etc. mit oder ohne Filterhilfen wie Aktivkohle, Metalloxide, etc. Ein weiteres Beispiel für die Entfernung von Partikeln aus der Siliconzusammensetzung (X) ist die Zentrifugation, wobei alle genannten oder möglichen Verfahren im Batch-Prozess oder kontinuierlich erfolgen können.

Das Verfahren zur Herstellung der Silicon-Mehrschichtverbunde aus einer oder mehreren Siliconzusammensetzungen (X) erfolgt vorzugsweise unter Reinraumbedingungen, bei denen Partikel größer 5 µm nicht vorkommen. Für die Auslegung der Produktionsanlage bedeutet das, dass die unvernetzten Siliconzusammensetzungen (X) nach der Entfernung eventuell enthaltener Partikel nur in Reinräumen der Klasse M4 bzw. 100 (nach Federal Standard 209 E) und besser gelagert und verarbeitet werden, bevorzugt in Reinräumen der Klasse 3 bzw. 10 und besser.

Das als Träger verwendete Trägermaterial spielt für die Herstellung der Mehrschichtverbunde eine untergeordnete Rolle. Lediglich die Oberflächengüte ist entscheidend, da Erhebungen oder Vertiefungen der Oberfläche direkt von der Siliconzusammensetzung (X) abgeformt werden. Vorzugsweise werden aus diesem Grund Trägermaterialien verwendet, deren Oberflächen besonders glatt sind und keine Vertiefungen oder Erhebungen enthalten, die größer als 5% bevorzugt 3% der herzustellenden Foliendicken sind. Beispiele für Trägermaterialien sind: Polyethylen, Polypropylen, Polyvinylchlorid, Polystyrol, Cellophan, Polyester (Polyethylenterephthalat, Polybutylenterephthalat, Polycarbonat, Polyethylennaphtalat), Fluor-haltige Polymere (Polytetrafluorethylen), Metallbänder oder -folien (als Endlosband oder über die skizzierten Vorlagerollen, es sind alle Metalle möglich, mit oder ohne Oberflächenbeschichtung). Die Dicke des verwendeten Trägermaterials spielt ebenfalls nur eine untergeordnete Rolle. Bevorzugte Dicken für Kunststoffträger oder Metallfolien betragen 10µm bis 200µm, für Metallbänder 200µm bis 2mm. Bevorzugte Trägermaterialien sind Metallfolien, Metallbänder und Kunststofffolien aus Polyethylen, Polypropylen, Polyethylenterephthalat, Polybutylenterephthalat sowie Polytetrafluoroethylen.

Die Laufgeschwindigkeit des Trägers zur Produktion der Siliconfolien liegt üblicherweise zwischen 0,1 und 1000 m/min, bevorzugt zwischen 0,5 und 500 m/min und besonders bevorzugt zwischen 1 und 100 m/min. Mit dem erfindungsgemäßen Verfahren können Bahnbreiten zwischen wenigen Zentimetern und mehreren Metern erreicht werden, wobei die bevorzugte Breite zwischen 10cm und 4m liegt, besonders bevorzugt zwischen 20cm und 3m.

Durch die Verwendung einer Schlitzdüse ist die Dicke der produzierten Siliconschicht nur Abhängig vom Materialfluss, der über die zuführende Pumpe eingestellt wird, der Bahngeschwindigkeit und der Dichte der verwendeten vernetzbaren Siliconzusammensetzungen (X). Die dynamische Viskosität bei 25 °C gemessen nach DIN53019 der Siliconzusammensetzungen (X) liegt zwischen 100 mPa●s und 1000 Pa●s, bevorzugt zwischen 200 mPa●s und 500 Pa●s und besonders bevorzugt zwischen 300 mPa●s und 100 Pa●s. Schlitzdüsen sind dem Fachmann aus dem Stand der Technik bekannt.

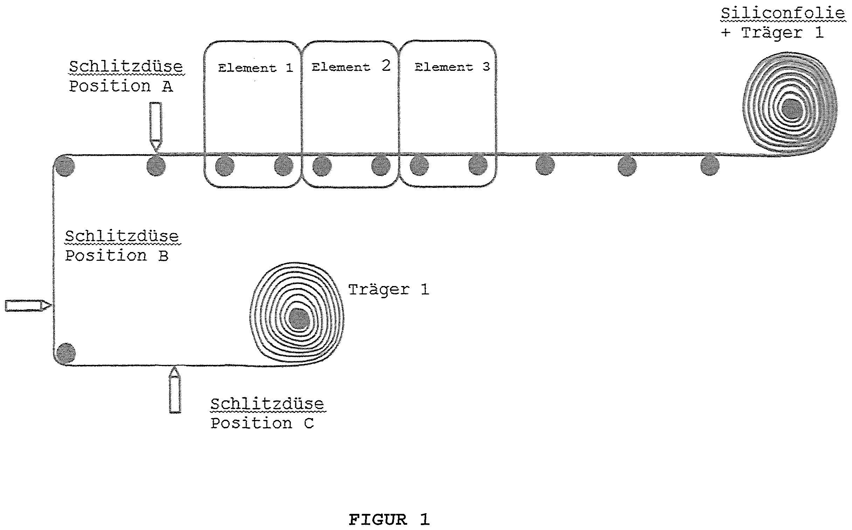

Im Folgenden werden mehrere Ausführungsformen des erfindungsgemäßen Verfahrens beispielhaft anhand von Figur 1 bis Figur 6 beschrieben. Diese sind jedoch nicht als abschließend für die Ausgestaltungsformen des erfindungsgemäßen Verfahrens zu verstehen.

In einer einfachen Ausführungsform erfolgt die Herstellung der erfindungsgemäßen Siliconfolien auf einer Produktionsanlage nach Figur 1.

Figur 1 dient der einfachen Veranschaulichung des erfindungsgemäßen Verfahrens. Bei einer Anordnung wie in Figur 1 dargestellt, wird die Siliconfolie dadurch erzeugt, dass die unvernetzte Siliconzusammensetzung (X) durch den Spalt der Schlitzdüse in Schritt i) gefördert wird, wobei die Fördermenge und die Geschwindigkeit des Trägers so anzupassen sind, dass die gewünschte Schichtdicke daraus resultiert. Die Spaltöffnung am Kopf der Schlitzdüse ist üblicherweise im Breiten-Bereich der herzustellenden Schicht, wobei auch deutliche Unterschiede möglich sind (wie auch aus den späteren Beispielen ersichtlich ist). Der Abstand der Schlitzdüse zum Träger liegt etwas über der gewünschten Schichtdicke der Folie. Bezogen auf eine 50 µm dicke Siliconfolie liegt der Abstand zwischen der Schlitzdüse und dem Träger üblicherweise zwischen 55 µm und 500 µm. Bevorzugt liegt der Abstand bezogen auf eine 50 µm dicke Siliconfolie zwischen 55 µm und 350 µm und besonders bevorzugt zwischen 55 µm und 200 µm.

Die Positionierung der Schlitzdüse zum Träger kann sowohl senkrecht von oben (Position A), horizontal (Position B) oder von unten (Position C) erfolgen. Der Winkel zwischen der Schlitzdüse und dem Trägermaterial beträgt in der Figur 1 in allen Positionen A bis C 90°, es sind jedoch andere Winkel wie weiter unten beschrieben möglich. In Figur 1 sind die Elemente 1 bis 3 abgebildet sie dienen für den Schritt ii). Ihre Anzahl ist lediglich als Beispiel und nicht beschränkend auf ihre Anzahl zu verstehen. Werden Siliconzusammensetzungen (X) verwendet, die kein Lösungsmittel enthalten, kann die Verwendung eines einzigen Elementes (beispielsweise für Heißluft, IR-Strahlung oder UV-Strahlung) ausreichend sein, um die Teilvernetzung oder/und Vernetzung im Schritt ii) zur Siliconfolie zu bewirken. Bei Siliconzusammensetzungen (X), die Lösungsmittel enthalten, ist es von Vorteil, wenn im Prozessschritt ii) die Entfernung des Lösungsmittels und der Vernetzungsschritt zur Siliconfolie getrennt werden, dafür werden mindestens zwei Elemente, Element 1 und Element 2 benötigt. Es können jedoch auch mehrere Elemente in Kombinationen für Schritt ii) eingesetzt werden. Beispielsweise dient in Figur 1 Element 1 dem Ablüften von Lösungsmittel, Element 2 dient der Vernetzung/Teilvernetzung und Element 3 dient der Nachbehandlung. Nachdem die Siliconfolie ausgehärtet ist, wird sie in Figur 1 zusammen mit dem Träger gesammelt bzw. aufgewickelt. Je nach Bahngeschwindigkeit und Anspringtemperatur der Siliconzusammensetzung (X) können die Längen der Ablüft-, Vernetzungs- und Nachbehandlungsstrecken der Elemente 1 bis 3 variieren. Die so gesammelte Siliconfolie auf Träger 1 wird dann beispielsweise in derselben oder einer weiteren Apparatur gemäß Figur 1 als Träger 1 verwendet um eine weitere Siliconschicht gemäß Schritt iv) und v) aufzubringen. Die Schritte iv) und v) können mehrfach wiederholt werden, bis die gewünschte Anzahl an Schichten erreicht ist. Im letzten Durchlauf der Schritte iv) und v) wird im Anschluss eine finale Vernetzung durchgeführt, falls vorher zumindest eine der Siliconschichten nur teilvernetzt wurde.

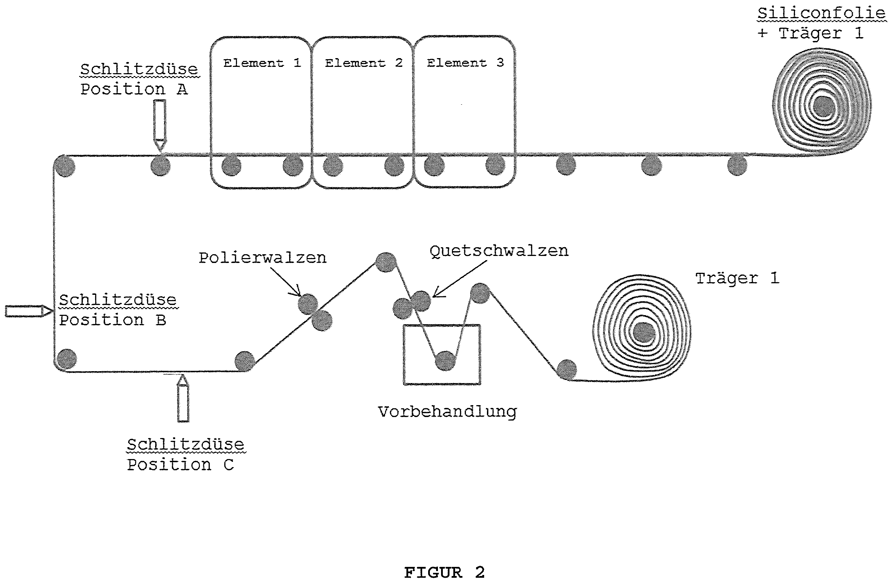

In Figur 2 erfolgt die Herstellung analog zu Figur 1 mit dem zusätzlichen Prozessschritt ia) einer Vorbehandlung des Trägers. Es handelt sich dabei um eine Tauchbehandlung des Trägers. Nach der Tauchbehandlung wird der Träger durch Quetsch- und Polierwalzen geführt um überschüssiges Vorbehandlungsmaterial zu entfernen.

Mehrschichtverbunde werden auch hier durch eine Wiederholung der Schritte iii), iv) und v) erhalten, wobei die zweite Schicht Silicon unvernetzt auf die durch- oder teilvernetzte erste Siliconschicht aus den Schritten i) bis iii) aufgetragen wird.

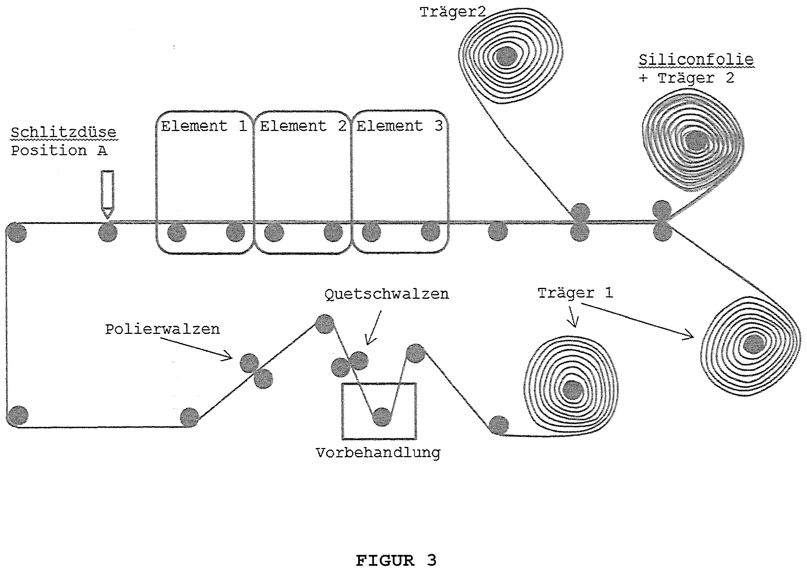

In Figur 3 erfolgt die Herstellung analog zu Figur 2 mit dem zusätzlichen Prozessschritt, der Verwendung eines zweiten Trägers Träger 2 im Schritt va) nach der Vernetzung zur Siliconfolie gemäß Schritt ii) um die Siliconfolie auf einen anderen Träger zu übertragen. Oder aber als Teilschritt des Schrittes viii) wenn der Silicon-Mehrschichtverbund fertig hergestellt wurde um diesen als finalen Schritt vom Träger 1 zu trennen. Es wird dazu der Träger 2 auf die Oberfläche der Siliconfolie bzw. des Silicon-Mehrschichtverbundes gebracht und etwas versetzt (kann aber auch gleichzeitig erfolgen) von Träger 1 getrennt und zusammen mit Träger 2 gesammelt.

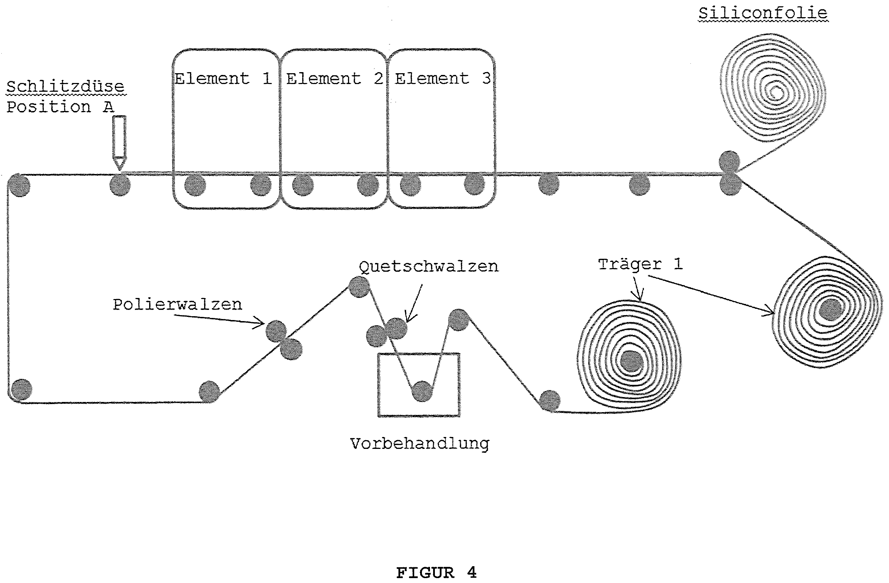

In Figur 4 erfolgt die Herstellung analog zu Figur 3 mit dem Unterschied dass die Siliconfolie bzw. der Silicon-Mehrschichtverbund direkt alleine gesammelt wird ohne auf einen weiteren Träger übertragen zu werden.

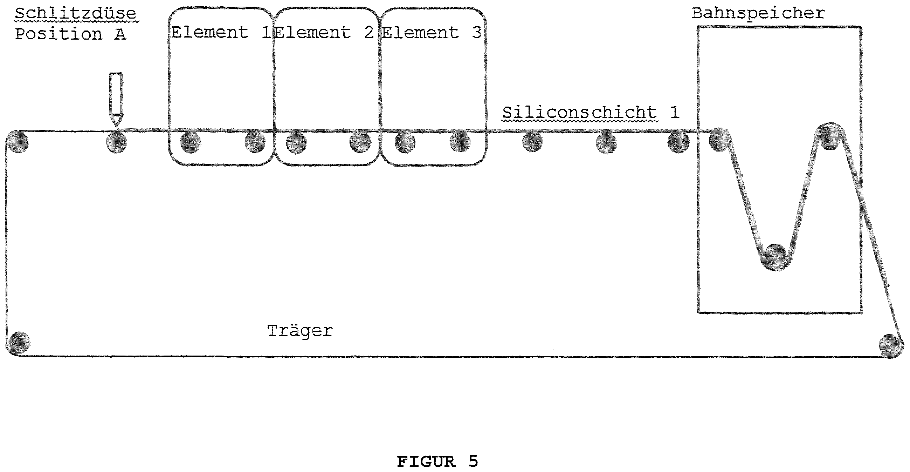

In Figur 5 erfolgt die Herstellung in Analogie zu Figur 1 jedoch ist mit dieser Anordnung eine kontinuierliche Herstellung des Silicon-Mehrschichtverbundes gemäß Schritte i) bis vii) mit nur einer Anlage möglich. Als zusätzliches Element wird ein Bandspeicher verwendet, wodurch die Länge des Bandes und damit des hergestellten Silicon-Mehrschichtverbundes erhöht wird. Dabei erfolgt hier die Auftragung und Aushärtung der einzelnen Schichten mit derselben Schlitzdüse und Elementen 1 bis 3.

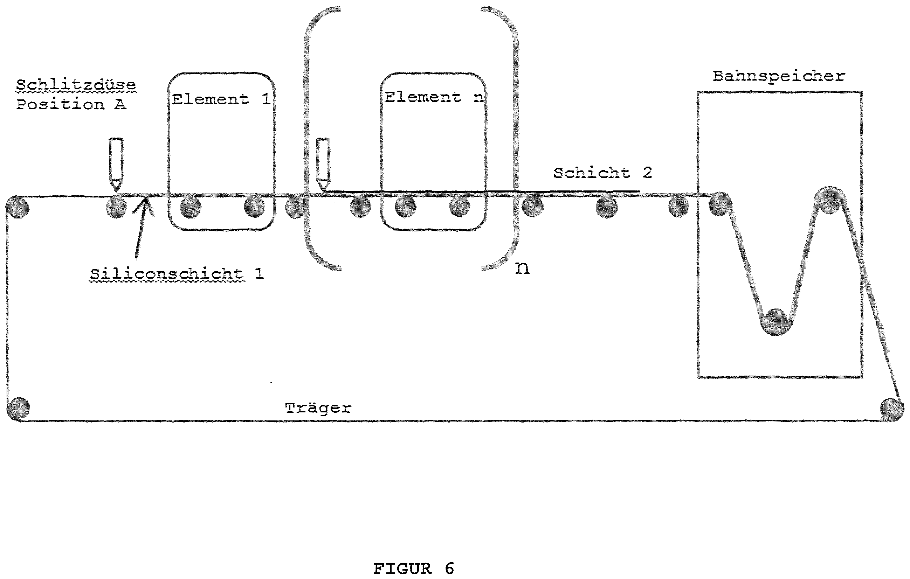

Figur 6 wird analog zu Figur 5 durchgeführt mit dem Unterschied, dass zusätzlich mindestens ein weitere Auftragsstelle in der Apparatur enthalten ist (also n = 1, 2, 3...) so dass für verschiedene Schichten unterschiedliche Schlitzdüsen und Elemente verwendet werden , wobei die Anzahl der tatsächlich verbauten Auftragsstellen nebensächlich ist. Besonders im Fall der Verwendung eines Endlosbandes kann die gewünschte Schichtfolge leicht wiederholt werden.

Als Siliconzusammensetzungen (X) können im Prinzip alle dem Stand der Technik bekannten Silicone verwendet werden. Es können additionsvernetzende, peroxidisch vernetzende, kondensationsvernetzende oder strahlenvernetzende Zusammensetzungen verwendet werden. Bevorzugt sind peroxidisch oder additionsvernetzende Zusammensetzungen. Besonders bevorzugt sind additionsvernetzende Zusammensetzungen.

Erfindungsgemäß verwendete additionsvernetzende Siliconzusammensetzungen (X) sind im Stand der Technik bekannt und enthalten im einfachsten Fall
(A) mindestens eine lineare Verbindungen, die Reste mit aliphatischen Kohlenstoff-Kohlenstoff-Mehrfachbindungen aufweisen,
(B) mindestens eine lineare Organopolysiloxane mit Si-gebundenen Wasserstoffatomen,
oder anstelle von (A) und (B)
(C) mindestens eine lineare Organopolysiloxane, die SiC-gebundene Reste mit aliphatischen Kohlenstoff-Kohlenstoff Mehrfachbindungen und Si-gebundene Wasserstoffatome aufweisen, und
(D) mindestens einen Hydrosilylierungskatalysator.

Bei den additionsvernetzenden Siliconzusammensetzungen (X) kann es sich um Einkomponenten-Siliconzusammensetzungen wie auch um Zweikomponenten-Siliconzusammensetzungen handeln.

Bei Zweikomponenten-Siliconzusammensetzungen können die beiden Komponenten der erfindungsgemäßen, additionsvernetzenden Siliconzusammensetzungen (X) alle Bestandteile in beliebiger Kombination enthalten, im Allgemeinen mit der Maßgabe, dass eine Komponente nicht gleichzeitig Siloxane mit aliphatischer Mehrfachbindung, Siloxane mit Si-gebundenem Wasserstoff und Katalysator, also im Wesentlichen nicht gleichzeitig die Bestandteile (A), (B) und (D) bzw. (C) und (D) enthält.

Die in den erfindungsgemäßen, additionsvernetzenden Siliconzusammensetzungen (X) eingesetzten Verbindungen (A) und (B) bzw. (C) werden bekanntermaßen so gewählt, dass eine Vernetzung möglich ist. So weist beispielsweise Verbindung (A) mindestens zwei aliphatisch ungesättigte Reste auf und (B) mindestens drei Si-gebundene Wasserstoffatome, oder Verbindung (A) weist mindestens drei aliphatisch ungesättigte Reste auf und Siloxan (B) mindestens zwei Si-gebundene Wasserstoffatome, oder aber anstelle von Verbindung (A) und (B) wird Siloxan (C) eingesetzt, welches aliphatisch ungesättigte Reste und Si-gebundene Wasserstoffatome in den oben genannten Verhältnissen aufweist. Auch möglich sind Mischungen aus (A) und (B) und (C) mit den oben genannten Verhältnissen von aliphatisch ungesättigten Resten und Si-gebundenen Wasserstoffatomen.

Die erfindungsgemäße additionsvernetzende Siliconzusammensetzung (X) enthält üblicherweise 30-95 Gew.%, bevorzugt 30-80 Gew.% und besonders bevorzugt 40-70 Gew.% (A). Die erfindungsgemäße additionsvernetzende Siliconzusammensetzung (X) enthält üblicherweise 0,1-60 Gew.%, bevorzugt 0,5-50 Gew.% und besonders bevorzugt 1-30 Gew.% (B). Falls die erfindungsgemäße additionsvernetzende Siliconzusammensetzung (X) die Komponente (C) enthält, sind üblicherweise 30-95 Gew.%, bevorzugt 30-80 Gew.%, besonders bevorzugt 40-70 Gew.% (C) in der Formulierung enthalten.

Bei der erfindungsgemäß eingesetzten Verbindung (A) kann es sich um siliciumfreie organische Verbindungen mit vorzugsweise mindestens zwei aliphatisch ungesättigten Gruppen sowie um Organosiliciumverbindungen mit vorzugsweise mindestens zwei aliphatisch ungesättigten Gruppen handeln oder auch um deren Mischungen.

Beispiele für siliciumfreie organische Verbindungen (A) sind, 1,3,5-Trivinylcyclohexan, 2,3-Dimethyl-1,3-butadien, 7-Methyl-3-methylen-1,6-octadien, 2-Methyl-1,3-butadien, 1,5-Hexadien, 1,7-Octadien, 4,7-Methylen-4,7,8,9-tetrahydroinden, Methylcyclopentadien, 5-Vinyl-2-norbornen, Bicyclo[2.2.1]hepta-2,5-dien, 1,3-Diisopropenylbenzol, vinylgruppenhaltiges Polybutadien, 1,4-Divinylcyclohexan, 1,3,5-Triallylbenzol, 1,3,5-Trivinylbenzol, 1,2,4-Trivinylcyclohexan, 1,3,5-Triisopropenylbenzol, 1,4-Divinylbenzol, 3-Methyl-heptadien-(1,5), 3-Phenyl-hexadien-(1,5), 3-Vinyl-hexadien-(1,5) und 4,5-Dimethyl-4,5-diethyl-octadien-(1,7), N,N'-Methylen-bis-acrylsäureamid, 1,1,1-Tris(hydroxymethyl)-propan-triacrylat, 1,1,1-Tris(hydroxymethyl)propantrimethacrylat, Tripropylenglykol-diacrylat, Diallylether, Diallylamin, Diallylcarbonat, N,N'-Diallylharnstoff, Triallylamin, Tris(2-methylallyl)amin, 2,4,6-Triallyloxy-1,3,5-triazin, Triallyl-s-triazin-2,4,6(1H,3H,5H)-trion, Diallylmalonsäureester, Polyethylenglykoldiacrylat, Polyethylenglykol Dimethacrylat, Poly(propylenglykol)methacrylat.

Vorzugsweise enthalten die erfindungsgemäßen additionsvernetzende Siliconzusammensetzungen (X) als Bestandteil (A) mindestens eine aliphatisch ungesättigte Organosiliciumverbindung, wobei alle bisher in additionsvernetzenden Zusammensetzungen verwendeten, aliphatisch ungesättigten Organosiliciumverbindungen eingesetzt werden können, wie beispielsweise Silicon-Blockcopolymere mit Harnstoffsegmenten, Silicon-Blockcopolymere mit Amid-Segmenten und/oder Imid-Segmenten und/oder Ester-Amid-Segmenten und/oder Polystyrol-Segmenten und/oder Silarylen-Segmenten und/oder Carboran-Segmenten und Silicon-Pfropfcopolymere mit Ether-Gruppen.

Als Organosiliciumverbindungen (A), die SiC-gebundene Reste mit aliphatischen Kohlenstoff-Kohlenstoff-Mehrfachbindungen aufweisen, werden vorzugsweise lineare oder verzweigte Organopolysiloxane aus Einheiten der allgemeinen Formel (I)

R⁴ₐR⁵_{b}SiO_{(4-a-b)/2} (I)

eingesetzt, wobei
**R⁴** unabhängig voneinander, gleich oder verschieden, ein von aliphatischen Kohlenstoff-Kohlenstoff-Mehrfachbindungen freien, organischen oder anorganischen Rest,
**R⁵** unabhängig voneinander, gleich oder verschieden einen einwertigen, substituierten oder nicht substituierten, SiC-gebundenen Kohlenwasserstoffrest mit mindestens einer aliphatischen Kohlenstoff-Kohlenstoff-Mehrfachbindung,
**a** 0, 1, 2 oder 3 ist, und
**b** 0, 1 oder 2 ist
bedeuten,
mit der Maßgabe, dass die Summe a + b kleiner oder gleich 3 ist und mindestens 2 Reste R⁵ je Molekül vorliegen.

Bei Rest R⁴ kann es sich um ein- oder mehrwertige Reste handeln, wobei die mehrwertigen Reste, wie beispielsweise bivalente, trivalente und tetravalente Reste, dann mehrere, wie etwa zwei, drei oder vier, Siloxy-Einheiten der Formel (I) miteinander verbinden.

Weitere Beispiele für R⁴ sind die einwertigen Reste -F, -Cl, - Br, OR⁶, -CN, -SCN, -NCO und SiC-gebundene, substituierte oder nicht substituierte Kohlenwasserstoffreste, die mit Sauerstoffatomen oder der Gruppe -C(O)- unterbrochen sein können, sowie zweiwertige, beidseitig gemäß Formel (I) Si-gebundene Reste. Falls es sich bei Rest R⁴ um SiC-gebundene, substituierte Kohlenwasserstoffreste handelt, sind bevorzugte Substituenten Halogenatome, phosphorhaltige Reste, Cyanoreste, -OR⁶, -NR⁶-, - NR⁶₂, -NR⁶-C(O)-NR⁶₂, -C(O)-NR⁶₂, -C(O)R⁶, -C(O)OR⁶, -SO₂-Ph und - C₆F₅. Dabei bedeuten R⁶ unabhängig voneinander, gleich oder verschieden ein Wasserstoffatom oder einen einwertigen Kohlenwasserstoffrest mit 1 bis 20 Kohlenstoffatomen und Ph gleich dem Phenylrest.
Beispiele für Reste R⁴ sind Alkylreste, wie der Methyl-, Ethyl-, n-Propyl-, iso-Propyl-, n-Butyl-, iso-Butyl-, tert-Butyl-, n-Pentyl-, iso-Pentyl-, neo-Pentyl-, tert-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest, Dodecylreste, wie der n-Dodecylrest, und Octadecylreste, wie der n-Octadecylrest, Cycloalkylreste, wie Cyclopentyl-, Cyclohexyl-, Cycloheptyl- und Methylcyclohexylreste, Arylreste, wie der Phenyl-, Naphthyl-, Anthryl- und Phenanthrylrest, Alkarylreste, wie o-, m-, p-Tolylreste, Xylylreste und Ethylphenylreste, und Aralkylreste, wie der Benzylrest, der α- und der ß-Phenylethylrest.

Beispiele für substituierte Reste R⁴ sind Halogenalkylreste, wie der 3,3,3-Trifluor-n-propylrest, der 2,2,2,2',2',2'-Hexafluorisopropylrest, der Heptafluorisopropylrest, Halogenarylreste, wie der o-, m- und p-Chlorphenylrest, -(CH₂)-N(R⁶)C(O)NR⁶₂, - (CH₂)ₒ-C(O)NR⁶₂, -(CH₂)ₒ-C(O)R⁶, -(CH₂)ₒ-C(O)OR⁶, - (CH₂)ₒ-C(O)NR⁶₂, -(CH₂)-C(O)-(CH₂)ₚC(O)CH₃, -(CH₂)-O-CO-R⁶, -(CH₂)-NR⁶-(CH₂)ₚ-NR⁶₂, -(CH₂)ₒ-O-(CH₂)ₚCH(OH)CH₂OH, -(CH₂)ₒ(OCH₂CH₂)ₚOR⁶, -(CH₂)ₒ-SO₂-Ph und -(CH₂)ₒ-O-C₆F₅, wobei R⁶ und Ph der oben dafür angegebenen Bedeutung entsprechen und o und p gleiche oder verschiedene ganze Zahlen zwischen 0 und 10 bedeuten.

Beispiele für R⁴ gleich zweiwertige, beidseitig gemäß Formel (I) Si-gebundene Reste sind solche, die sich von den voranstehend für Rest R⁴ genannten einwertigen Beispiele dadurch ableiten, dass eine zusätzliche Bindung durch Substitution eines Wasserstoffatoms erfolgt, Beispiele für derartige Reste sind -(CH₂)-, -CH(CH₃)-, -C(CH₃)₂-, -CH(CH₃)-CH₂-, -C₆H₄-, -CH(Ph)-CH₂-, - C(CF₃)₂-, -(CH₂)ₒ-C₆H₄-(CH₂)ₒ-, -(CH₂)ₒ-C₆H₄-C₆H₄-(CH₂)ₒ-, -(CH₂O)ₚ, (CH₂CH₂O)ₒ, -(CH₂)ₒ-Oₓ-C₆H₄-SO₂-C₆H₄-Oₓ-(CH₂)ₒ-, wobei x 0 oder 1 ist, und Ph, o und p die voranstehend genannte Bedeutung haben.

Bevorzugt handelt es sich bei Rest R⁴ um einen einwertigen, von aliphatischen Kohlenstoff-Kohlenstoff-Mehrfachbindungen freien, SiC-gebundenen, gegebenenfalls substituierten Kohlenwasserstoffrest mit 1 bis 18 Kohlenstoffatomen, besonders bevorzugt um einen einwertigen, von aliphatischen Kohlenstoff-Kohlenstoff-Mehrfachbindungen freien, SiC-gebundenen Kohlenwasserstoffrest mit 1 bis 6 Kohlenstoffatomen, insbesondere um den Methyl- oder Phenylrest.

Bei Rest R⁵ kann es sich um beliebige, einer Anlagerungsreaktion (Hydrosilylierung) mit einer SiH-funktionellen Verbindung zugängliche Gruppen handeln.

Falls es sich bei Rest R⁵ um SiC-gebundene, substituierte Kohlenwasserstoffreste handelt, sind als Substituenten Halogenatome, Cyanoreste und -OR⁶ bevorzugt, wobei R⁶ die obengenannte Bedeutung hat.

Bevorzugt handelt es sich bei Rest R⁵ um Alkenyl- und Alkinylgruppen mit 2 bis 16 Kohlenstoffatomen, wie Vinyl-, Allyl-, Methallyl-, 1-Propenyl-, 5-Hexenyl-, Ethinyl-, Butadienyl-, Hexadienyl-, Cyclopentenyl-, Cyclopentadienyl-, Cyclohexenyl-, Vinylcyclohexylethyl-, Divinylcyclohexylethyl-, Norbornenyl-, Vinylphenyl- und Styrylreste, wobei Vinyl-, Allyl- und Hexenylreste besonders bevorzugt verwendet werden.

Das Molekulargewicht des Bestandteils (A) kann in weiten Grenzen variieren, etwa zwischen 10² und 10⁶ g/mol. So kann es sich bei dem Bestandteil (A) beispielsweise um ein relativ niedermolekulares alkenylfunktionelles Oligosiloxan, wie 1,2-Divinyltetramethyldisiloxan, handeln, jedoch auch um ein über kettenständige oder endständige Si-gebundene Vinylgruppen verfügendes hochpolymeres Polydimethylsiloxan, z.B. mit einem Molekulargewicht von 10⁵ g/mol (mittels NMR bestimmtes Zahlenmittel). Auch die Struktur der den Bestandteil (A) bildenden Moleküle ist nicht festgelegt; insbesondere kann die Struktur eines höhermolekularen, also oligomeren oder polymeren Siloxans linear, cyclisch, verzweigt oder auch harzartig, netzwerkartig sein. Lineare und cyclische Polysiloxane sind vorzugsweise aus Einheiten der Formel R⁴₃SiO_{1/2}, R⁵R⁴₂SiO_{1/2}, R⁵R⁴SiO_{1/2} und R⁴₂SiO_{2/2} zusammengesetzt, wobei R⁴ und R⁵ die vorstehend angegebene Bedeutung haben. Verzweigte und netzwerkartige Polysiloxane enthalten zusätzlich trifunktionelle und/oder tetrafunktionelle Einheiten, wobei solche der Formeln R⁴SiO_{3/2}, R⁵SiO_{3/2} und SiO_{4/2} bevorzugt sind. Selbstverständlich können auch Mischungen unterschiedlicher, den Kriterien des Bestandteils (A) genügender Siloxane eingesetzt werden.

Besonders bevorzugt als Komponente (A) ist die Verwendung vinylfunktioneller, im wesentlichen linearer Polydiorganosiloxane mit einer Viskosität von 0,01 bis 500 000 Pa●s, besonders bevorzugt von 0,1 bis 100 000 Pa●s, jeweils bei 25°C.

Als Organosiliciumverbindung (B) können alle hydrogenfunktionellen Organosiliciumverbindungen eingesetzt werden, die auch bisher in additionsvernetzbaren Zusammensetzungen eingesetzt worden sind.

Als Organopolysiloxane (B), die Si-gebundene Wasserstoffatome aufweisen, werden vorzugsweise lineare, cyclische oder verzweigte Organopolysiloxane aus Einheiten der allgemeinen Formel (III)

R⁴_{c}H_{d}SiO_{(4-c-d)/2} (III)

eingesetzt, wobei
**R⁴** die oben angegebene Bedeutung hat,
**c** 0,1, 2 oder 3 ist und
**d** 0, 1 oder 2 ist,
mit der Maßgabe, dass die Summe von c + d kleiner oder gleich 3 ist und mindestens zwei Si gebundene Wasserstoffatome je Molekül vorliegen.

Vorzugsweise enthält das erfindungsgemäß eingesetzte Organopolysiloxan (B) Si-gebundenen Wasserstoff im Bereich von 0,04 bis 1,7 Gewichtsprozent (Gew.%), bezogen auf das Gesamtgewicht des Organopolysiloxans (B).

Das Molekulargewicht des Bestandteils (B) kann ebenfalls in weiten Grenzen variieren, etwa zwischen 10² und 10⁶ g/mol. So kann es sich bei dem Bestandteil (B) beispielsweise um ein relativ niedermolekulares SiH-funktionelles Oligosiloxan, wie Tetramethyldisiloxan, handeln, jedoch auch um ein über kettenständig oder endständig SiH-Gruppen verfügendes hochpolymeres Polydimethylsiloxan oder ein SiH-Gruppen aufweisendes Siliconharz.

Auch die Struktur der den Bestandteil (B) bildenden Moleküle ist nicht festgelegt; insbesondere kann die Struktur eines höhermolekularen, also oligomeren oder polymeren SiH-haltigen Siloxans linear, cyclisch, verzweigt oder auch harzartig, netzwerkartig sein. Lineare und cyclische Polysiloxane (B) sind vorzugsweise aus Einheiten der Formel R⁴₃SiO_{1/2}, HR⁴₂SiO_{1/2}, HR⁴SiO_{2/2} und R⁴₂SiO_{2/2} zusammengesetzt, wobei R⁴ die vorstehend angegebene Bedeutung hat. Verzweigte und netzwerkartige Polysiloxane enthalten zusätzlich trifunktionelle und/oder tetrafunktionelle Einheiten, wobei solche der Formeln R⁴SiO_{3/2}, HSiO_{3/2} und SiO_{4/2} bevorzugt sind, wobei R⁴ die vorstehend angegebene Bedeutung hat.

Selbstverständlich können auch Mischungen unterschiedlicher, den Kriterien des Bestandteils (B) genügender Siloxane eingesetzt werden. Besonders bevorzugt ist die Verwendung niedermolekularer SiH-funktioneller Verbindungen wie Tetrakis(dimethylsiloxy)silan und Tetramethylcyclotetrasiloxan, sowie höhermolekularer, SiH-haltiger Siloxane, wie Poly(hydrogenmethyl)siloxan und Poly(dimethylhydrogenmethyl)siloxan mit einer Viskosität bei 25°C von 10 bis 20 000 mPa●s, oder analoge SiH-haltige Verbindungen, bei denen ein Teil der Methylgruppen durch 3,3,3-Trifluorpropyl- oder Phenylgruppen ersetzt ist.

Bestandteil (B) ist vorzugsweise in einer solchen Menge in den erfindungsgemäßen vernetzbaren Siliconzusammensetzungen (X) enthalten, dass das Molverhältnis von SiH-Gruppen zu aliphatisch ungesättigten Gruppen aus (A) bei 0,1 bis 20, besonders bevorzugt zwischen 0,3 und 2,0 liegt.

Die erfindungsgemäß eingesetzten Komponenten (A) und (B) sind handelsübliche Produkte bzw. nach in der Chemie gängigen Verfahren herstellbar.

Anstelle von Komponente (A) und (B) können die erfindungsgemäßen Siliconzusammensetzungen Organopolysiloxane (C), die gleichzeitig aliphatische Kohlenstoff-Kohlenstoff-Mehrfachbindungen und Si-gebundene Wasserstoffatome aufweisen, enthalten. Auch können die erfindungsgemäßen Siliconzusammensetzungen alle drei Komponenten (A), (B) und (C) enthalten.

Falls Siloxane (C) eingesetzt werden, handelt es sich vorzugsweise um solche aus Einheiten der allgemeinen Formeln (IV), (V) und (VI)

R⁴_{f}SiO_{4/2} (IV)

R⁴_{g}R⁵SiO_{3-g/2} (V)

R⁴ₕHSiO_{3-h/2} (VI)

wobei
**R⁴** und **R⁵** die oben dafür angegebene Bedeutung haben
**f** 0, 1, 2 oder 3 ist,
**g** 0, 1 oder 2 ist und
**h** 0, 1 oder 2 ist,
mit der Maßgabe, dass je Molekül mindestens 2 Reste R⁵ und mindestens 2 Si-gebundene Wasserstoffatome vorliegen.

Beispiele für Organopolysiloxane (C) sind solche aus SiO_{4/2}, R⁴₃SiO_{1/2}-, R⁴₂R⁵SiO_{1/2}- und R⁴₂HSiO_{1/2}- Einheiten, sogenannte MP-Harze, wobei diese Harze zusätzlich R⁴SiO_{3/2}- und R⁴₂SiO-Einheiten enthalten können, sowie lineare Organopolysiloxane im Wesentlichen bestehend aus R⁴₂R⁵SiO_{1/2}-, R⁴₂SiO- und R⁴HSiO-Einheiten mit R⁴ und R⁵ gleich der obengenannten Bedeutung.

Die Organopolysiloxane (C) besitzen vorzugsweise eine durchschnittliche Viskosität von 0,01 bis 500 000 Pa●s, besonders bevorzugt 0,1 bis 100 000 Pa●s jeweils bei 25°C. Organopolysiloxane (C) sind nach in der Chemie gängigen Methoden herstellbar.

Als Hydrosilylierungskatalysator (D) können alle dem Stand der Technik bekannten Katalysatoren verwendet werden. Komponente (D) kann ein Platingruppenmetall sein, beispielsweise Platin, Rhodium, Ruthenium, Palladium, Osmium oder Iridium, eine metallorganische Verbindung oder eine Kombination davon. Beispiele für Komponente (D) sind Verbindungen wie Hexachloroplatin(IV)-säure, Platindichlorid, Platinacetylacetonat und Komplexe der besagten Verbindungen, die in einer Matrix oder einer kernschalenartigen Struktur eingekapselt sind. Zu den Platinkomplexen mit niedrigem Molekulargewicht der Organopolysiloxane gehören 1,3-Diethenyl-1,1,3,3-Tetramethyldisiloxan-Komplexe mit Platin. Weitere Beispiele sind Platinphosphitkomplexe oder Platinphosphinkomplexe. Für licht- oder UV-härtende Zusammensetzungen können beispielsweise Alkylplatinkomplexe wie Derivate von Cyclopentadienyltrimethylplatin(IV), Cyclooctadienyldimethylplatin(II) oder Diketonatokomplexe wie zum Beispiel Bisacetylacetonatoplatin(II) verwendet werden, um die Additionsreaktion mit Hilfe von Licht zu starten. Diese Verbindungen können in einer Harzmatrix eingekapselt sein.

Die Konzentration von Komponente (D) ist zum Katalysieren der Hydrosilylierungsreaktion der Komponenten (A) und (B) und (C) bei Einwirkung ausreichend, um die hier in dem beschriebenen Verfahren erforderliche Wärme zu erzeugen. Die Menge an Komponente (D) kann zwischen 0,1 und 1000 Teile pro Million (ppm), 0,5 und 100 ppm oder 1 und 25 ppm des Platingruppenmetalls betragen, je nach Gesamtgewicht der Komponenten. Die Härtungsrate kann gering sein, wenn der Bestandteil des Platingruppenmetalls bei unter 1 ppm liegt. Die Verwendung von mehr als 100 ppm des Platingruppenmetalls ist unwirtschaftlich oder setzt die Lagerstabilität der Siliconzusammensetzung (X) herab.

Die additionsvernetzende Siliconzusammensetzungen (X) können optional alle weiteren Zusatzstoffe enthalten, die auch bisher zur Herstellung von additionsvernetzbaren Zusammensetzungen eingesetzt wurden. Beispiele für verstärkende Füllstoffe (F), die als Komponente in den erfindungsgemäßen additionsvernetzende Siliconzusammensetzungen (X) eingesetzt werden können, sind pyrogene oder gefällte Kieselsäuren mit BET-Oberflächen von mindestens 50 m²/g sowie Ruße und Aktivkohlen wie Furnace-Ruß und Acetylen-Ruß, wobei pyrogene und gefällte Kieselsäuren mit BET-Oberflächen von mindestens 50 m²/g bevorzugt sind. Die genannten Kieselsäurefüllstoffe können hydrophilen Charakter haben oder nach bekannten Verfahren hydrophobiert sein. Der Gehalt der erfindungsgemäßen vernetzbaren Siliconzusammensetzungen (X) an aktiv verstärkendem Füllstoff liegt im Bereich von 0 bis 70 Gew.-%, vorzugsweise bei 0 bis 50 Gew. -%.

Besonders bevorzugt sind die vernetzbaren additionsvernetzenden Siliconzusammensetzungen (X) dadurch gekennzeichnet, dass der Füllstoff (E) oberflächenbehandelt ist. Die Oberflächenbehandlung wird durch die im Stand der Technik bekannten Verfahren zur Hydrophobierung feinteiliger Füllstoffe erzielt.

Bevorzugte Füllstoffe (E) weisen infolge einer Oberflächenbehandlung einen Kohlenstoffgehalt von mindestens 0,01 bis maximal 20 Gew.%, bevorzugt zwischen 0.1 und 10 Gew.%, besonders bevorzugt zwischen 0,5 bis 5 Gew.% auf. Besonders bevorzugt sind vernetzbare additionsvernetzende Siliconzusammensetzungen (X) die dadurch gekennzeichnet sind, dass der Füllstoff (E) eine oberflächenbehandelte Kieselsäure, aufweisend 0,01 bis 2 Gew.% Si-gebundene, aliphatisch ungesättigte Gruppen bedeutet. Beispielsweise handelt es sich bei diesen um Si-gebundene Vinylgruppen. In der erfindungsgemäßen additionsvernetzende Siliconzusammensetzungen (X) wird der Bestandteil (E) bevorzugt als einzelne oder ebenfalls bevorzugt als eine Mischung mehrerer feinteiliger Füllstoffe verwendet.

Die erfindungsgemäße additionsvernetzende Siliconzusammensetzung (X) kann wahlweise als Bestandteile weitere Zusätze zu einem Anteil von bis zu 70 Gew.%, vorzugsweise 0,0001 bis 40 Gew.%, enthalten. Diese Zusätze können z.B. inaktive Füllstoffe, harzartige Polyorganosiloxane, die von den Siloxanen (A), (B) und (C) verschieden sind, verstärkende und nicht verstärkende Füllstoffe, Fungizide, Duftstoffe, rheologische Additive, Korrosionsinhibitoren, Oxidationsinhibitoren, Lichtschutzmittel, flammabweisend machende Mittel und Mittel zur Beeinflussung der elektrischen Eigenschaften, Dispergierhilfsmittel, Lösungsmittel, Haftvermittler, Pigmente, Farbstoffe, Weichmacher, organische Polymere, Hitzestabilisatoren usw. sein. Hierzu zählen Zusätze, wie Quarzmehl, Diatomeenerde, Tone, Kreide, Lithopone, Ruße, Graphit, Metalloxide, Metallcarbonate, -sulfate, Metallsalze von Carbonsäuren, Metallstäube, Fasern, wie Glasfasern, Kunststoffasern, Kunststoffpulver, Farbstoffe, Pigmente usw.

Diese Füllstoffe können zudem wärmeleitend oder elektrisch leitend sein. Beispiele für wärmeleitende Füllstoffe sind Aluminiumnitrid; Aluminumoxid; Bariumtitanat; Berylliumoxid; Bornitrid; Diamant; Grafit; Magnesiumoxid; partikuläres Metall wie beispielsweise Kupfer, Gold, Nickel oder Silber; Siliziumcarbid; Wolframcarbid; Zinkoxid und eine Kombination davon. Wärmeleitende Füllstoffe sind im Stand der Technik bekannt und im Handel erhältlich. Zum Beispiel CB-A20S und Al-43-Me sind Aluminiumoxid-Füllstoffe in verschiedenen Partikelgrößen, die im Handel bei Showa-Denko erhältlich sind, und AA-04, AA-2 und AAl 8 sind Aluminiumoxid-Füllstoffe, die im Handel bei Sumitomo Chemical Company erhältlich sind. Silber-Füllstoffe sind im Handel bei Metalor Technologies U.S.A. Corp. of Attleboro, Massachusetts, U.S.A., erhältlich. Bornitrid-Füllstoffe sind im Handel bei Advanced Ceramics Corporation, Cleveland, Ohio, U.S.A., erhältlich. Zu den Verstärkungsfüllstoffen gehören Silica und Kurzfasern wie beispielsweise KEVLAR-Kurzfaser^{®}. Es können eine Kombination aus Füllstoffen mit verschiedenen Partikelgrößen und unterschiedlicher Partikelgrößenverteilung verwendet werden.

Die additionsvernetzende Siliconzusammensetzung (X) kann weitere optionale Komponenten enthalten. Zu den Beispielen für weitere optionale Komponenten gehören unter anderem (F) ein oder mehrere Lösungsmittel, (G) ein oder mehrere Inhibitoren.

Die additionsvernetzende Siliconzusammensetzung (X) kann zusätzlich optional ein Lösungsmittel (F) enthalten. Es ist jedoch darauf zu achten, dass das Lösemittel (F) keine nachteiligen Effekte auf das Gesamtsystem hat. Geeignete Lösungsmittel (F) sind im Stand der Technik bekannt und im Handel erhältlich. Das Lösungsmittel (F) kann beispielsweise ein organisches Lösungsmittel mit 3 bis 20 Kohlenstoffatomen sein. Zu den Beispielen für Lösungsmittel (F) gehören aliphatische Kohlenwasserstoffe wie beispielsweise Nonan, Decalin und Dodecan; aromatische Kohlenwasserstoffe wie beispielsweise Mesitylen, Xylen und Toluen; Ester wie beispielsweise Ethylacetat und Butyrolacton; Ether wie beispielsweise n-Butylether und Polyethylenglycolmonomethylether; Ketone wie beispielsweise Methylisobutylketon und Methylpentylketon; Siliconfluid wie beispielsweise lineare, verzweigte und zyklische Polydimethylsiloxane und Kombinationen aus diesen Lösungsmitteln (F). Die optimale Konzentration eines bestimmten Lösungsmittels (F) in der additionsvernetzenden Siliconzusammensetzung (X) kann durch Routineversuche leicht bestimmt werden. Je nach Gewicht der Verbindung kann die Menge des Lösungsmittels (F) zwischen 0 und 95 Gew.% bzw. zwischen 1 und 95 Gew.% liegen.

Die additionsvernetzende Siliconzusammensetzung (X) kann zusätzlich optional (G) Inhibitoren und Stabilisatoren enthalten. Inhibitoren und Stabilisatoren (G) dienen der gezielten Einstellung der Verarbeitungszeit, Anspringtemperatur und Vernetzungsgeschwindigkeit der erfindungsgemäßen additionsvernetzenden Siliconzusammensetzung (X). Diese Inhibitoren und Stabilisatoren (G) sind auf dem Gebiet der additionsvernetzenden Zusammensetzungen sehr gut bekannt. Beispiele gebräuchlicher Inhibitoren sind acetylenische Alkohole, wie 1-Ethinyl-1-cyclohexanol, 2-Methyl-3-butin-2-ol und 3.5-Dimethyl-1-hexin-3-ol, 3-Methyl-1-dodecin-3-ol, Polymethylvinylcyclosiloxane wie 1,3,5,7-Tetravinyltetramethyltetracyclosiloxan, niedermolekulare Siliconöle mit Methylvinyl-SiO_{1/2}-Gruppen und/oder R₂vinylSiO_{1/2}-Endgruppen, wie Divinyltetramethydisiloxan, Tetravinyldimethyldisiloxan, Trialkylcyanurate, Alkylmaleate, wie Diallylmaleate, Dimethylmaleat und Diethylmaleat, Alkylfumarate, wie Diallylfumarat und Diethylfumarat, organische Hydroperoxide wie Cumolhydroperoxid, tert-Butylhydroperoxid und Pinanhydroperoxid, organische Peroxide, organische Sulfoxide, organische Amine, Diamine und Amide, Phosphane und Phosphite, Nitrile, Triazole, Diaziridine und Oxime. Die Wirkung dieser Inhibitorzusätze (G) hängt von ihrer chemischen Struktur ab, so dass die Konzentration individuell bestimmt werden muss. Inhibitoren und Inhibitormischungen (G) werden vorzugsweise in einem Mengenanteil von 0,00001 Gew.% bis 5 Gew.% bezogen auf das Gesamtgewicht der Mischung zugesetzt, bevorzugt 0,00005 bis 2 Gew.% und besonders bevorzugt 0,0001 bis 1 Gew.%.

Die folgende Aufzählung steht beispielhaft für auf dem Markt kommerziell erhältliche Siliconzusammensetzungen (X), die geeignet sind für die Herstellung dünner Schichten nach dem erfindungsgemäßen Verfahren. Es handelt sich dabei meist um additionsvernetzende Siliconzusammensetzungen (X). Je nach Viskosität der kommerziellen Siliconzusammensetzungen (X) kann für eine bessere Verarbeitbarkeit Lösungsmittel (F) zugegeben werden.

Materialien der WACKER Chemie AG, München: ELASTOSIL^{®} P-Reihe (7010, 7600, 7613, 7161-160, 7616-195, 7618, 7619, 7622, 7623, 7624, 7628, 7629, 7630, 7633, 7636, 7642-220, 7670, 671, 7676, 7682, 7683/15, 7683/25, 7683/47, 7683/50, 7683/55, 7684/60, 7685, 7686, 7687, 7688, 7700, 7710, 7720, 7731, 7742, 7770, 7707 US, 7915, ...), ELASTOSIL^{®} M-Reihe (4115, 4125, 4370, 4400, 4440, 4441, 4470, 4600, 4601, 4615, 4630, 4635, 4640, 4645, 4641, 4643, 4644, 4670, 4647, 4648, 4670), ELASTOSIL^{®} RT-Reihe (601, 602, 604, 607, 615, 617, 619, 620, 622, 623, 624, 625, 626, 627, 628, 629, 630, 633, 646, 670, 672, 675, 678, 685, ...), ELASTOSIL^{®} SOLAR-Reihe (2000, 2200, 2202, 3210, ...), LSR: ELASTOSIL^{®} LR-Reihe (3003/03, 3003/05, 3003/10, 3003/20, 3070/20, 3844/20, 3846/20, 3856/20, 3003/30, 3004/30, 3005/30, 3040/30, 3044/30, 3065/30, 3070/30, 3071/30, 3072/30, 3843/30, 3844/30, 3846/30, 3856/30, 3003/40, 3003/50, 3003/60, 3003/70, 3003/80, 3003/85, 3004/40, 3004/50, 3004/60, 3004/70, 3005/40, 3005/50, 3005/60, 3040/40, 3040/50, 3040/60, 3043/40, 3043/50, 3043/60, 3043/70, 3015/70, 3023/60, 3092/65, 3094/60, 3065/50, 3066/40, 3066/60, 3066/80, 3070/40, 3070/50, 3070/60, 3071/40, 3071/50, 3071/60, 3072/40, 3074/60, 3076/70, 3170/40, 3841/50, 3842/40, 3842/50, 3842/60, 3842/70, 3162, ...), ELASTOSIL^{®} FLR-Reihe (3900/40, 3900/60, 3905/40, 3905/60, ...), HTV: ELASTOSIL^{®} R-Reihe, WACKER SILGEL^{®}-Reihe (610, 611, 612, 613, 616, 619, ...), SEMICOSIL^{®}-Reihe, POWERSIL^{®}-Reihe, LUMISIL^{®}-Reihe, GENIOMER^{®}-Reihe, SILPURAN^{®}-Reihe, DEHESIVE^{®}-Reihe.

Manchmal ist eine Vorbehandlung des Trägers als zusätzlicher Prozessschritt ia) von Vorteil.

Erfolgt eine Vorbehandlung so kann dieser schritt ia) beispielsweise über eine Tauchbehandlung des Trägers erfolgen. Andere chemische oder physikalische Vorbehandlungsmethoden sind ebenfalls möglich, Beispiele hierfür sind: Sprühbehandlung, Reinigungsverfahren, Entfettungsverfahren, Plasmabehandlung oder die Abscheidung von Schichten (Bsp.: Fluorkohlenstoffschichten). Ob ein Vorbehandlungsschritt ia) notwendig oder sinnvoll ist, hängt vom verwendeten Trägermaterial ab. Sollte eine zu starke chemische oder physikalische Anhaftung des Siliconelastomers auf dem verwendeten Trägermaterial ein Ablösen der Folie vom Träger nach der Vernetzung nicht ermöglichen, kann dies durch Vorbehandlung des Trägers verhindert werden. Um das Trennen der Siliconfolie vom Träger zu erleichtern erfolgt bevorzugt die Behandlung des Trägers mit einem Trennmittel, wobei alle dem Stand der Technik bekannten Trennmittel verwendet werden können, wie zum Beispiel: Detergentien wie nichtionische Tenside (Polyalkylenglycolether, Alkylglucoside, Fettalkoholpropylate, Alkylpolyglucoside, Oktylphenolethoxylate, Nonylphenolethoxylate), anionische Tenside (Alkylcarboxylate, Alkylbenzolsulfonate, Fettalkoholsulfate), kationische Tenside (meist quartäre Ammoniumverbindungen wie Tetraalkylammoniumhalogenide oder Esterquats) oder amphotere Tenside (Betaine, Sulfobetaine). Es können alle handelsüblichen Tenside oder Tensidmischungen für eine Vorbehandlung verwendet werden, wie z.B. die Surfynol^{®}-Serie, die Dynol^{™}-Serie, die EnviroGem^{®}-Serie, die Leunapon F-Serie, die Leunapon FU-Serie, die Leunapon P-Serie, die Metaupon-Serie, die Hansanol AS 240-Serie, die Hansanol NS-242 Serie, die Hansanol NS 243-Serie, die Hansanol NS 252-Serie, die Hansanol NS-262-Serie, die Hansanyl OS-Serie, die Hansanid CFAD, die Hansanolat FA-Serie, die Hansanolat NP-Serie, die Hansateric CAPB-Serie, die Cremophor^{®}-Serie, die Eusapon^{®}-Serie, die Jordapon^{®}-Serie, die AVANEL-Serie, die Lutensit^{®}-Serie, die Lutensol-Serie, die Pluracare^{®}-Serie, die Plurafac^{®}-Serie oder die Pluronic-Serie.

Das Trennmittel oder eine Mischung verschiedener Trennmittel und Additive wird vorzugsweise in einer wässrigen, einer alkoholischen, oder einer wässrig-alkoholischen Mischung eingesetzt, wobei als Alkoholkomponente bevorzugt lineare und verzweigte aliphatische Alkohole wie z.B. Methanol, Ethanol, Propanol, Butanol, Pentanol, Hexanol, Heptanol, Octanol, Isopropanol, Isobutanol, etc. Verwendung finden.

Vor dem Aufbringen der Siliconzusammensetzung (X) auf den Träger ist es bevorzugt, das überschüssige Vorbehandlungsmaterial wieder vom Träger zu entfernen, was bevorzugt mit Hilfe von Quetsch- und/oder Polierwalzen und/oder Polierteller erfolgt. Anordnung, Größe, Geschwindigkeit oder Anzahl der verwendeten Aggregate spielen nur eine untergeordnete Rolle. Bevorzugt ist außerdem die Verwendung mindestens einer Polierwalze bzw. eines Poliertellers, besonders bevorzugt ist die Verwendung einer Kombination aus Quetsch- und Polierwalzen.

Die Schlitzdüse in Schritt i) und iv) steht in einem Winkel zwischen 10° und 90° zum Träger. Bevorzugt sind Winkel zwischen 30° und 90° und besonders bevorzugt Winkel zwischen 50° und 90°.

In einer bevorzugten Ausführungsform ist der Abstand der Schlitzdüse zum Träger in Schritt i) sowie zum 1ten bzw. weiteren Schichtverbund im Schritt iv) mindestens 2 µm, bevorzugt mindestens 5 µm, größer als die Schichtdicke der hergestellten Siliconfolie.

Die Fahrweise der Schlitzdüse spielt für die Berechnungen der Schichtdicken keine Rolle, da es sich um ein vordosiertes Verfahren handelt (bead mode, curtain mode, short curtain mode). Bei Bedarf kann an die Schlitzdüse ein Unterdruck angelegt werden, um die Fahrweise bei der angegebenen Geschwindigkeit zu erreichen. Der Massenstrom der Siliconzusammensetzung (X) wird über geeignete Pumpen, wie z.B. Zahnradpumpen, Kolbenpumpen, Membranpumpen, etc. erzeugt und eingestellt.

Die Aktivierung zur teilweisen oder ganzen Vernetzung in den Schritten ii) sowie v) und vii) kann unabhängig voneinander thermisch, über IR-Strahlung oder über UV-Strahlung erfolgen. Bei raumtemperaturvernetzenden Systemen ist die Zimmertemperatur für die Aushärtung ausreichend, so dass keine zusätzliche Zufuhr von Energie erfolgen muss. Auch eine Mikrowellenaktivierung oder Aktivierung durch Ultraschall ist möglich.

Bei UV-vernetzenden Systemen wird der Katalysator (D) der Hydrosilylierungsreaktion der additionsvernetzenden Siliconzusammensetzung (X) durch Bestrahlung aktiviert um eine teilweise oder ganze Vernetzung zu erreichen. Es können alle dem Stand der Technik bekannten Lichtquellen wie zum Beispiel LED, Quecksilberdampflampen, dotierte Quecksilberdampflampen, Xenonlampen oder Laser verwendet werden. Vorzugsweise werden Wellenlängen zwischen 250 und 800 nm eingestrahlt, besonders bevorzugt sind Wellenlängen zwischen 300 und 500 nm. Die Anordnung der Lichtquellen ist beliebig, wobei der Abstand zwischen der Lichtquelle und der zu vernetzenden Siliconzusammensetzung (X) zwischen wenigen Millimetern und mehreren Zentimetern variieren kann. Die im Schritt iii) gegebenenfalls aufgebrachten Zwischenschichten sind abhängig von der geplanten Verwendung. Es können beispielsweise leitfähige Puder oder Pulver als Zwischenschicht aufgebracht werden. Geeignete Materialien sind beispielsweise Graphite, Carbon-Nanotubes, Leitfähigkeitsruße, Metallplättlchen, Metallstäbchen, Metall-Nano-Wires. Auch das gezielte Aufbringen von definierten Leiterbahnen fällt unter diesen Schritt. Es können aber auch andere polymerisierbare Zusammensetzungen als Zwischenschicht aufgebracht werden, welche gegebenenfalls Füllstoffe enthalten können, wie z.B. Acrylate, Epoxide oder Polyurethane. Das Einbringen bereits vernetzter Kunststoffschichten, z.B. ASA, ABS, A/MMA, BR, CA, CR, COC, EP, EPM, EPDM, EVA, FKM, UF, HIPS, MF, MBS, NR, PF PE, PP, PBT, PET, PU, BC, PI, PIB, PMMI, PMMA, PS, SB, PTFE, PVAC, PVB, PVC, PVDF, SAN, SBS oder TPU. Zwischenschichten aus organischen anorganischen Materialien wie z.B. Glas oder Papier sind ebenfalls möglich. Bevorzugte Zwischenschichten sind elektrisch leitfähig.

Im einfachsten Fall wird der erfindungsgemäße Silicon-Mehrschichtverbund direkt mit dem Träger gesammelt. Weitere Möglichkeiten bestehen darin die Siliconfolie oder den erfindungsgemäßen Silicon-Mehrschichtverbund in einem Zwischenschritt va) vom Träger zu trennen und ihn dann zu sammeln, oder vom Träger auf einen anderen Träger zu übertragen und dann zusammen mit dem anderen Träger zu sammeln.

Gründe für die Notwendigkeit der Übertragung auf einen anderen Träger können z.B. die mangelhafte thermische oder UV-Beständigkeit des Trägers , Preisdifferenzen zwischen den Trägermaterialien, Oberflächeneigenschaften, Oberflächengüten, Dicke, Gewicht, etc. sein. Der Schritt des Trägerwechsels hat keinerlei Einfluss auf die anderen Prozessschritte.

Anschließend kann die so gesammelte Siliconfolie oder der Silicon-Mehrschichtverbund entweder direkt weiterverarbeitet oder bis zur weiteren Verwendung gelagert werden. Wird erst im Zuge der Weiterverarbeitung der Träger von der Siliconfolie entfernt, kann der Zeitpunkt (ob vor oder nach der Weiterverarbeitung) eine Rolle spielen. Die weitere Verarbeitung des erfindungsgemäße Silicon-Mehrschichtverbundes kann mit allen dem Stand der Technik bekannten Verfahren erfolgen, beispielsweise für die Formgebung des erfindungsgemäßen Silicon-Mehrschichtverbundes, um diesen in der gewünschten Anwendung einsetzen zu können. Beispiele hierfür, ohne die Erfindung zu beschränken, sind schneiden mit diversen Methoden wie Messer, Laser, Wasser oder Partikelstrahl oder stanzen. Auch ein Fixieren durch beispielsweise Kleben, etc. ist möglich.

Ein weitere Gegenstand der vorliegenden Erfindung sind Silicon-Mehrschichtverbunde hergestellt mit dem erfindungsgemäßen Verfahren, mit unabhängigen Schichtdicken der einzelnen Siliconschichten von 0,1 bis 200 µm, bevorzugt von 1 bis 150 µm und besonders bevorzugt von 2 bis 100 µm und jeweils einer Dickengenauigkeit von ±5 % gemessen auf einer Fläche von 200 cm²; bevorzugt eine Dickengenauigkeit von jeweils ±3 %.

Die mit dem beschriebenen erfindungsgemäßen Verfahren hergestellten Silicon-Mehrschichtverbunde haben weiterhin den Vorteil, dass sie als dielektrische elektroaktive Polymere (EAP) in Aktoren, Sensoren oder Generatoren verwendet werden können.

Besonders bei Anwendungen als EAPs im Bereich der Aktoren oder der Generatoren werden im Verlauf der Lebensdauer mehrere Millionen Schwingungszyklen durchlaufen. Ein Vorteil der mit Hilfe des erfindungsgemäßen Verfahrens hergestellten erfindungsgemäße Silicon-Mehrschichtverbunde ist eine sehr hohe Dauerbelastungsbeständigkeit, welche durch die Gleichmäßigkeit und Partikelfreiheit der erfindungsgemäßen Silicon-Mehrschichtverbunde bedingt wird. Für die Auslegung der Betriebsspannung der Bauteile sind die oben genannten Eigenschaften ebenfalls von größter Bedeutung, da sie einen direkten Einfluss auf die Durchbruchfeldstärke besitzen. Das maximale elektrische Feld wiederum hat einen direkten Einfluss auf den Wirkungsgrad und die Performance der Aktoren oder Generatoren.

Gleichmäßigkeit bedeutet, dass die Schichtdicke der gehärteten Siliconschichten auf einer bestimmten Fläche nur minimal variiert. Bei erfindungsgemäßen Silicon-Mehrschichtverbunden, die mit dem erfindungsgemäßen Verfahren hergestellt werden, variiert die einzelne gehärtete Siliconschichtdicke maximal um ±5% innerhalb einer Fläche von 200 cm² (=Dickengenauigkeit). Das bedeute, dass beispielsweise eine einzelne gehärtete Siliconschicht mit einer mittleren Schichtdicke von 100 µm, auf einer Fläche von 200 cm² keine Stelle aufweist, an der die Schichtdicke kleiner als 95 µm oder größer als 105 µm ist. Oder anders gesagt, eine Siliconschicht mit einer mittleren Schichtdicke von 100 µm und einer Dickengenauigkeit von ±5% weist über die gesamte Fläche von 200 cm² stets eine Dicke von mindestens 95 und höchstens 105 µm auf egal wo auf der 200 cm² Fläche die Schichtdicke bestimmt wird.

Ein besonderer Vorteil der erfindungsgemäßen Herstellung von Mehrschichtverbunden liegt darin, dass verschiedenartige Siliconzusammensetzungen (X) unabhängig voneinander verwendet werden können, wobei die mechanischen Eigenschaften der einzelnen gehärteten Siliconschicht dann eine untergeordnete Rolle spielen. Beispiele hierfür sind Hart-Weich-Verbunde, bei denen mindestens ein Material ein Silicongel ist, Hart-Weich-Verbunden, bei denen mindestens ein Material ein sprödes, hartes Material darstellt, Verbunde aus Siliconen mit unterschiedlichen physikalischen oder chemischen Eigenschaften wie beispielsweise Brechungsindex, thermische Leitfähigkeit, elektrische Leitfähigkeit, etc.

Je nach Anwendung ist eine Vielzahl von erfindungsgemäßen Anordnungen oder Aufbauten derartiger Systeme möglich, welche durch stapeln, falten, aufrollen, etc. erreicht werden können.

### Beispiele:

In den nachstehend beschriebenen Beispielen beziehen sich alle Angaben von Teilen und Prozentsätzen, falls nicht anders angegeben, auf das Gewicht. Sofern nicht anders angegeben, werden die nachstehenden Beispiele bei einem Druck der umgebenden Atmosphäre, also etwa bei 1000 hPa, und bei Raumtemperatur, also bei 25 °C, bzw. bei einer Temperatur, die sich beim Zusammengeben der Reaktanden bei Raumtemperatur ohne zusätzliche Heizung oder Kühlung einstellt, durchgeführt. Im Folgenden beziehen sich alle Viskositätsangaben auf eine Temperatur von 25 °C. Die nachfolgenden Beispiele erläutern die Erfindung, ohne dabei beschränkend zu wirken.

In den Beispielen wurde als Träger ein PET (Polyethylenterephthalat) Film der Firma Mitsubishi Polymer Film GmbH verwendet (HOSTAPHAN^{®}). Derartige Folien sind auch von anderen Herstellern erhältlich, zum Beispiel MYLAR^{®} (DuPont Teijin Films), MELINEX^{®} (DuPont Teijin Films), SCOTCHPAK^{®} (3M Company, St. Paul, MN).

Es wurde eine Schlitzdüse der Fa. COATEMA Coating Machinery GmbH verwendet, wobei die Art der Schlitzdüse für die Herstellung keine entscheidende Rolle spielt. Alternativ können auch Schlitzdüsen anderer Hersteller (Fa. FMP Technology GmbH, Mitsubishi Heavy Industries, etc.) verwendet werden.

Die absolute Schichtdicke wird mit Hilfe einer REM-Analyse eines Kryoschnitts bestimmt, die Oberflächengüte und Rauhigkeit werden mit Hilfe des Konfokal-Mikroskops Leica DCM 3D ermittelt.

Es werden folgende Abkürzungen verwendet:
- Bsp.: Beispiel
- Nr.: Nummer
- PDMS: Polydimethylsiloxan
- LSR: Liquid Silicone Rubber
- HTV: Hochtemperaturvernetzend
- Gew.%: Gewichtsprozent, w/w
- U_{w}: Substrat- oder Bahngeschwindigkeit
- ρ: Dichte
- h: Nassfilmdicke
- B: Beschichtungsbreite

Die Beispiele 1 bis 5 wurden mit einem Verfahren gemäß Figur 1 durchgeführt, wobei die Position A der Schlitzdüse gewählt wurde. In Beispiel 6 (Vergleichsbeispiel, nicht erfindungsgemäß) erfolgte der Auftrag der Siliconzusammensetzung mit Hilfe eines Kastenrakels. Die Beispiele 7 bis 10 wurden mit einem Verfahren gemäß Figur 3 durchgeführt, wobei die Position A der Schlitzdüse gewählt wurde. Der Winkel der Schlitzdüse betrug stets 90°.

### Beispiel 1:

Herstellung einer 50 µm Dicken Folie aus dem RTV-2 Material ELASTOSIL^{®} P 7670 A/B (Mischungsverhältnis A:B = 1:1, Dichte nach ISO 2811 = 1,03 g/cm³, Härte Shore A nach ISO 868 = 7, Reißdehnung nach ISO 37 = 600 %, Reißfestigkeit nach ISO 37 = 1,8 N/mm², Viskosität nach Mischen der Komponenten nach ISO 3219 = 1800 mPa s bei einer Scherrate von 1 s⁻¹, Weiterreißwiderstand nach ASTM D 624 B = 2,1 N/mm).

Um eine Nassfilmdicke von 50 µm bei einer Bahngeschwindigkeit von 1 m/min und einer Schichtbreite von 0,3 m bei der gegebenen Dichte einzustellen, liegt die Fördermenge bei 15,45 ml/min. Gemessene Schichtdicke/Oberflächenrauhigkeit: 50 ± 1,5 µm Durchschlagsspannung nach ASTM D 3755: 35 kV/mm

Vor dem erneuten einspannen in die Beschichtungsanlage wird die hergestellte Siliconschicht, die sich auf dem Trägermaterial befindet, an 90 % der Fläche mit einem leitfähigen Ruß durch Aufpinseln einer Dispersion beschichtet. Als zweite Schicht wird wiederum das oben genannte Siliconmaterial verwendet, wobei eine 20 µm dicke Schicht aufgetragen und vernetzt wird. Der Vorgang wird zweimal wiederholt, so dass sich ein Schichtaufbau aus drei elektrisch leitfähigen und vier isolierenden Schichten ergibt, wobei die letzte Siliconschicht erneut 50 µm dick hergestellt wird. Die Dickengenauigkeit des gesamten Schichtverbundes liegt bei ± 15 µm, die Dickengenauigkeit jeder einzelnen Schicht liegt bei ± 2 µm.

### Beispiel 2:

Herstellung einer 20 µm Dicken Folie aus dem RTV-2 Material ELASTOSIL^{®} P 7684/60 A/B (Mischungsverhältnis A:B = 1:1, Dichte nach ISO 2811 = 1,08 g/cm³, Härte Shore A nach ISO 868 = 12, Reißdehnung nach ISO 37 = 600 %, Reißfestigkeit nach ISO 37 = 3 N/mm², Viskosität nach Mischen der Komponenten nach ISO 3219 = 1500 mPa s bei einer Scherrate von 1 s⁻¹, Weiterreißwiderstand nach ASTM D 624 B = 13 N/mm).

Um eine Nassfilmdicke von 20 µm bei einer Bahngeschwindigkeit von 2 m/min und einer Schichtbreite von 0,3 m bei der gegebenen Dichte einzustellen, liegt die Fördermenge bei 32,4 ml/min.
Gemessene Schichtdicke/Oberflächenrauhigkeit: 20 ± 1 µm
Durchschlagsspannung nach ASTM D 3755: 50 kV/mm

In einem zweiten Schritt wird auf die vulkanisierte Schicht aus ELASTOSIL^{®} P 7684/60 eine Schicht mit einer Dicke von 100 µm aus Silpuran^{®} 2110 (Mischungsverhältnis A:B = 1:1, Penetration nach DIN ISO 2137 [1/10 mm] Hohlkegel 62,5 g, 60 s, Viskosität nach Mischen der Komponenten nach ISO 3219 = 30.000 mPa s bei einer Scherrate von 1 s-1) aufgetragen.

### Beispiel 3:

Herstellung einer 100 µm Dicken Folie aus dem LSR Material, das ELASTOSIL^{®} LR 3003/40, nach oder vor dem Mischen der Komponente verdünnt auf einen Lösungsmittelanteil von 50 Vol% (Alkanfraktion, Handelsname ISOPAR-E, Firma: ExxonMobil Chemical), (Mischungsverhältnis A:B = 1:1, Dichte nach ISO 2811 = 1,0 g/cm³, Härte Shore A nach ISO 868 = 42, Reißdehnung nach ISO 37 = 610 %, Reißfestigkeit nach ISO 37 = 10 N/mm², Weiterreißwiderstand nach ASTM D 624 B = 33 N/mm, Viskosität nach Mischen der Komponenten nach ISO 3219 = 5300 mPa s bei einer Scherung von 1 s⁻¹). Für eine Schichtdicke des Elastomers von 100 µm ist, bei 50 Vol% Lösungsmittelanteil, eine Nassfilmdicke von 200 µm bei einer Bahngeschwindigkeit von 5 m/min und einer Schichtbreite von 0,3 m bei der gegebenen Dichte eine Fördermenge von 300 ml/min notwendig. Das Lösungsmittel wird vor der Vernetzung abgedampft. Wie dieser Prozess im Detail gefahren wird, spielt für die herzustellende Folie keine Rolle. In diesem Beispiel wird die Bahn durch einen 3 m langen Trockenofen mit drei verschiedenen Temperaturzonen (erster Meter = 120 °C, zweiter Meter = 140 °C, dritter Meter = 165 °C) gefahren um zuerst das Lösungsmittel abzudampfen und danach durch die erhöhte Temperatur eine Vernetzung des Materials zu erzielen.
Gemessene Schichtdicke/Oberflächenrauhigkeit: 100 ± 3 µm
Durchschlagsspannung nach ASTM D 3755: 40 kV/mm

Direkt nach der Vernetzung wird eine Dispersion aus elektrisch leitenden Rußpartikeln (Leitruß) in Isopar E (90 Gew% Lösungsmittel) mit Hilfe eines Druckkopfs aufgetragen, bevor in einem dritten Schritt nach Ablüften des Lösungsmittels aus der Leitrußschicht eine zweite, 25 µm dicke Schicht aus ELASTOSIL^{®} P 7670 aufgetragen und vernetzt wird. Anschließend werden eine Schicht Leitruß, eine Schicht ELASTOSIL^{®} P 7670, eine Schicht Leitruß und eine Schicht ELASTOSIL^{®} LR 3003/40 (in Isopar E, siehe oben) aufgetragen.

### Beispiel 4:

Es wurde analog zu Beispiel 3 verfahren jedoch mit dem Unterschied dass die Bahngeschwindigkeit 10 m/min betrug mit einer entsprechenden Fördermenge von 600 ml/min.
Gemessene Schichtdicke/Oberflächenrauhigkeit: 100 ± 4 µm
Durchschlagsspannung nach ASTM D 3755: 40 kV/mm

### Beispiel 5:

Herstellung einer 200 µm Dicken Folie aus einem Silicon mit der Zusammensetzung:
49 % eines vinylterminierten, linearen Polydimethylsiloxans mit einer mittleren Kettenlänge von ca. 220.
23 % eines Me₂Si-H-terminierten, linearen Polydimethylsiloxans mit einer mittleren Kettenlänge von ca. 220.
23 % einer hydrophobierten, pyrogenen Kieselsäure mit einer BET-Oberfläche von 130 m²/g
5 % eines linearen Kammvernetzers mit einer Kettenlänge von ca. 220 Einheiten und einem Si-H-Gehalt von 0,15 Gew%

Die Mischung enthält zudem
10 ppm Platinkatalysator (Divinyltetramethyldisiloxankomplexe, bezogen auf das Metall)
250 ppm 1-Ethinylcyclohexanol zur Einstellung der Topfzeit.

Härte Shore A nach ISO 868 = 26, Dichte nach ISO 2811 = 1,05 g/cm³, Reißdehnung nach ISO 37 = 490 %, Reißfestigkeit nach ISO 37 = 5,9 N/mm², Weiterreißwiderstand nach ASTM D 624 B = 11,6 N/mm, Viskosität nach ISO 3219 = 6900 mPa s bei einer Scherung von 1 s⁻¹.

Um eine Nassfilmdicke von 200 µm bei einer Bahngeschwindigkeit von 10 m/min und einer Schichtbreite von 0,3 m bei der gegebenen Dichte einzustellen, liegt die Fördermenge bei 630 ml/min.
Gemessene Schichtdicke/Oberflächenrauhigkeit: 200 ± 5 µm
Durchschlagsspannung nach ASTM D 3755: >50 kV/mm

Eine zweite, 200 µm dicke Schicht aus SILPURAN^{®} 2112 wird mit den gleichen Parametern in einem Folgeschritt nach 80%igem Aushärten der ersten Schicht aufgetragen und vernetzt.

Beispiel 6: (Vergleichsbeispiel, nicht erfindungsgemäß) Herstellung einer 50 µm dicken Folie aus dem RTV-2 Material ELASTOSIL^{®} P 7670 A/B (Mischungsverhältnis A:B = 1:1, Dichte nach ISO 2811 = 1,03 g/cm³, Härte Shore A nach ISO 868 = 7, Reißdehnung nach ISO 37 = 600 %, Reißfestigkeit nach ISO 37 = 1,8 N/mm², Viskosität nach Mischen der Komponenten nach ISO 3219 = 1800 mPa●s bei einer Scherung von 1 s⁻¹, Weiterreißwiderstand nach ASTM D 624 B = 2,1 N/mm). Die Einstellung der Schichtdicke auf 50 µm erfolgt durch manuelles Anpassen des Abstandes zwischen dem verwendeten Kastenrakel und der Bahn.
Gemessene Schichtdicke/Oberflächenrauhigkeit: 50 ± 6 µm
Durchschlagsspannung nach ASTM D 3755: 22 kV/mm

### Beispiel 7: (gemäß Figur 3 mit Vorbehandlung)

Das Tauchbad in Figur 3 wird mit einer Lösung aus 2 Gew.% der handelsüblichen Tensidmischung Green Care No 5 der Firma Tana Chemie GmbH in Wasser verwendet. Die Rotationsgeschwindigkeit der Quetschwalzen ist gleich der Bahngeschwindigkeit, die der Polierwalzen ist das Fünffache der Bahngeschwindigkeit.

Herstellung einer 50 µm dicken Folie aus dem RTV-2 Material ELASTOSIL^{®} P 7670 A/B (Mischungsverhältnis A:B = 1:1, Dichte nach ISO 2811 = 1,03 g/cm³, Härte Shore A nach ISO 868 = 7, Reißdehnung nach ISO 37 = 600 %, Reißfestigkeit nach ISO 37 = 1,8 N/mm², Viskosität nach Mischen der Komponenten nach ISO 3219 = 1800 mPa●s bei einer Scherung von 1 s⁻¹, Weiterreißwiderstand nach ASTM D 624 B = 2,1 N/mm).

Um eine Nassfilmdicke von 50 µm bei einer Bahngeschwindigkeit von 1 m/min und einer Schichtbreite von 0,3 m bei der gegebenen Dichte einzustellen, liegt die Fördermenge bei 15,45 ml/min.
Gemessene Schichtdicke/Oberflächenrauhigkeit: 50 ± 1,5 µm
Durchschlagsspannung nach ASTM D 3755: 35 kV/mm

### Beispiel 8: (gemäß Figur 3 mit Vorbehandlung)

Das Tauchbad in Figur 3 wird mit einer Lösung aus 2 Gew% der handelsüblichen Tensidmischung Green Care No 5 der Firma Tana Chemie GmbH in Wasser verwendet. Die Rotationsgeschwindigkeit der Quetschwalzen ist gleich der Bahngeschwindigkeit, die der Polierwalzen ist das Fünffache der Bahngeschwindigkeit. Der Vorbehandlungsschritt wird vor der Herstellung der ersten Siliconschicht durchgeführt, um ein späteres Ablösen des Mehrschichtverbundes vom Träger zu erleichtern.

Herstellung einer 20 µm dicken Folie aus einem Silicon mit der Zusammensetzung:
35 Gew.% eines vinylterminierten, linearen Polydimethylsiloxans mit einer mittleren Kettenlänge von ca. 600.
15 Gew.% eines vinylterminierten, linearen Polydimethylsiloxans mit einer mittleren Kettenlänge von ca. 220.
50 Gew.% eines linearen Kammvernetzers, Me₂SiH-terminiert, mit einer Kettenlänge von ca. 220 Einheiten und einem Si-H-Gehalt von 0,015 Gew.%

Die Mischung enthält zudem
10 ppm Platinkatalysator (Divinyltetramethyldisiloxankomplexe, bezogen auf das Metall)
250 ppm 1-Ethinylcyclohexanol zur Einstellung der Topfzeit.

Härte Shore A nach ISO 868 = 2, Dichte nach ISO 2811 = 0,97 g/cm³, Reißdehnung nach ISO 37 = 350 %, Reißfestigkeit nach ISO 37 = 1,9 N/mm², Weiterreißwiderstand nach ASTM D 624 B = 2,6 N/mm, Viskosität nach ISO 3219 = 3500 mPa●s bei einer Scherung von 1 s⁻¹.

Um eine Nassfilmdicke von 20 µm bei einer Bahngeschwindigkeit von 10 m/min und einer Schichtbreite von 0,3 m bei der gegebenen Dichte einzustellen, liegt die Fördermenge bei 64,02 ml/min.
Gemessene Schichtdicke/Oberflächenrauhigkeit: 20 ± 1 µm
Durchschlagsspannung nach ASTM D 3755: 35 kV/mm

Als zweite Schicht wird eine Schicht mit ELASTOSIL^{®} RT 625 mit einer Schichtdicke von 50 µm aufgetragen.

### Beispiel 9: (gemäß Figur 3 mit Vorbehandlung)

Das Tauchbad in Figur 3 wird mit einer Lösung aus 2 Gew% der handelsüblichen Tensidmischung Green Care No 5 der Firma Tana Chemie GmbH in Wasser verwendet. Die Rotationsgeschwindigkeit der Quetschwalzen ist gleich der Bahngeschwindigkeit, die der Polierwalzen ist das Fünffache der Bahngeschwindigkeit. Der Vorbehandlungsschritt wird vor der Herstellung der ersten Siliconschicht durchgeführt, um ein späteres Ablösen des Mehrschichtverbundes vom Träger zu ermöglichen.

Als erste Schicht werden 50 µm ELASTOSIL^{®} P 7670 mit einer Geschwindigkeit von 10 m/min Bandgeschwindigkeit aufgetragen, die Daten zum Materialfluss ergeben sich aus den bereits in den vorhergehenden Beispielen gezeigten Berechnungen.

Anschließend wird eine leitfähige Tinte mit einer Schichtdicke von wenigstens 100 nm auf die erste Siliconschicht gebracht.

Als dritte Schicht wird eine 0,5 µm dicke Siliconschicht mit folgender Zusammensetzung aufgebracht:
49 Gew.% eines vinylterminierten, linearen Polydimethylsiloxans mit einer mittleren Kettenlänge von ca. 220.
23 Gew.% eines Me₂Si-H-terminierten, linearen Polydimethylsiloxans mit einer mittleren Kettenlänge von ca. 220.
23 Gew.% einer hydrophobierten, pyrogenen Kieselsäure mit einer BET-Oberfläche von 130 m²/g
5 Gew.% eines linearen Kammvernetzers mit einer Kettenlänge von ca. 220 Einheiten und einem Si-H-Gehalt von 0,15 Gew%

Die Mischung enthält zudem
10 ppm Platinkatalysator (Divinyltetramethyldisiloxankomplexe, bezogen auf das Metall)
250 ppm 1-Ethinylcyclohexanol zur Einstellung der Topfzeit.
Vor der Auftragung werden 1 l Mischung mit 3 l Lösungsmittel (Alkanfraktion, Handelsname Isopar E) verdünnt, die Dichte der Lösung liegt bei 0,98 g/cm³, die Viskosität der Lösung nach ISO 3219 = 30 mPa●s bei einer Scherung von 1 s⁻¹.

Härte Shore A nach ISO 868 = 26, Dichte des Elastomers nach ISO 2811 = 1,05 g/cm³, Reißdehnung nach ISO 37 = 490 %, Reißfestigkeit nach ISO 37 = 5,9 N/mm², Weiterreißwiderstand nach ASTM D 624 B = 11,6 N/mm, Viskosität nach ISO 3219 = 6900 mPa●s bei einer Scherung von 1 s⁻¹.
Durchschlagsspannung nach ASTM D 3755: 85 kV/mm

Als vierte Schicht wird eine leitfähige Tinte mit einer Schichtdicke von wenigstens 100 nm auf die erste Siliconschicht gebracht.

In einem fünften Auftrag werden 50 µm ELASTOSIL^{®} P 7670 mit einer Geschwindigkeit von 10 m/min Bandgeschwindigkeit aufgetragen.

## Patentansprüche

1. Verfahren zur Herstellung von Silicon-Mehrschichtverbunden, bei denen mindestens zwei Schichten aus gehärtetem Silicon mit jeweils einer Schichtdicke von 0,1 bis 200 µm bestehen, wobei jede der einzelnen Siliconschichten eine Dickengenauigkeit von ±5 % gemessen auf einer Fläche von 200 cm² aufweist, **dadurch gekennzeichnet, dass**
i) eine lösungsmittelhaltige oder lösungsmittelfreie, vernetzbare Siliconzusammensetzung (X) durch den Spalt einer Schlitzdüse auf einen sich bewegenden Träger aufgetragen wird,
ii) anschließend aus der Siliconschicht, welche sich auf der Trägerfolie ausbildet das Lösungsmittel, falls vorhanden, entfernt und die Siliconschicht teilweise vernetzt wird, so dass sie einen Vernetzungsgrad von mindestens 40% und höchstens 90% aufweist,
iii) gegebenenfalls Zwischenschichten aufgetragen werden,
so dass ein 1ter Schichtverbund, aus Träger, einer vernetzten Siliconschicht sowie gegebenenfalls Zwischenschichten entsteht,
iv) eine lösungsmittelhaltige oder lösungsmittelfreie, vernetzbare Siliconzusammensetzung (X) durch den Spalt einer Schlitzdüse auf den sich bewegenden 1ten Schichtverbund aufgetragen wird,
v) anschließend aus der Siliconschicht, welche sich auf dem 1ten Schichtverbund ausbildet das Lösungsmittel, falls vorhanden, entfernt und die Siliconschicht teilvernetzt wird, so dass sie einen Vernetzungsgrad von mindestens 40% und höchstens 90% aufweist,
vi) gegebenenfalls die Schritte iii) bis v) noch mindestens 1 mal wiederholt werden,
vii) eine finale Vernetzung der Siliconschichten erfolgt, da in den Schritten ii) und v) nur eine Teilvernetzung stattfand,
viii) anschließend der entstandene Silicon-Mehrschichtverbund vom Träger getrennt werden kann,
mit folgenden Maßgaben:
- die Schlitzdüse in Schritt i) und iv) steht in einem Winkel zwischen 10° und 90° zum Träger;
- die Laufgeschwindigkeit des Trägers bzw. des 1ten sowie weiteren Schichtverbunde in den Schritten i) sowie iv) liegt zwischen 0,1 und 1000 m/min;
- die dynamische Viskosität bei 25°C gemessen nach DIN 53019 der Siliconzusammensetzung (X) liegt zwischen 100 mPa·s und 1000 Pa·s;
- die Oberfläche des Trägers enthalten keine Vertiefungen oder Erhebungen, die größer als 5% der herzustellenden Foliendicken sind, und
- Partikel die größer als 1/3 der einzelnen Siliconschichtdicke sind, aus der vernetzbaren Siliconzusammensetzung (X) vor ihrer Verwendung entfernt werden.

2. Silicon-Mehrschichtverbunden hergestellt mit dem Verfahren gemäß Anspruch 1, wobei jede der einzelnen Siliconschichten Schichtdicken von 0,1 bis 200 µm, und eine Dickengenauigkeit von ±3 % gemessen auf einer Fläche von 200 cm² aufweist.

3. Verwendung der Silicon-Mehrschichtverbunden gemäß Anspruch 2 als dielektrische elektroaktive Polymere (EAP) in Aktoren, Sensoren oder Generatoren.

4. Verwendung der Silicon-Mehrschichtverbunden gemäß Anspruch 2 als Barrierefolien im Medizin- oder Lebensmittelbereich, Isolierbänder, Schutzfolien, Verpackungsmaterial, Wundauflagen, Funktionsschichten in Kleidung, Stoff- oder Gastrennungsschicht, Kochfolie, Garfolie, Folien für Display-Anwendungen, Airbags oder Weinkorken.

## Claims

1. Method for producing multilayer silicone composites, in which at least two layers consist of cured silicone each with a layer thickness of 0.1 to 200 µm, where each of the individual silicone layers has a thickness precision of ± 5% as measured over an area of 200 cm²,
**characterized in that**
i) a solvent-containing or solvent-free, crosslinkable silicone composition (X) is applied through the slot of a slot die to a moving carrier,
ii) subsequently the solvent, if present, is removed from the silicone layer which forms on the carrier film, and the silicone layer is partially crosslinked, so that it has a degree of crosslinking of at least 40% and at most 90%,
iii) optionally intermediate layers are applied,
to give a 1st layer composite, composed of carrier, one crosslinked silicone layer, and optionally intermediate layers,
iv) a solvent-containing or solvent-free, crosslinkable silicone composition (X) is applied through the slot of a slot die to the moving 1st layer composite,
v) subsequently the solvent, if present, is removed from the silicone layer which forms on the 1st layer composite, and the silicone layer is partially crosslinked, so that it has a degree of crosslinking of at least 40% and at most 90%,
vi) optionally steps iii) to v) are repeated at least once more,
vii) there is a final crosslinking of the silicone layers, since only partial crosslinking took place in steps ii) and v),
viii) subsequently the resulting multilayer silicone composite can be separated from the carrier,
with the following provisos:
- the slot die in step i) and iv) is at an angle of between 10° and 90° to the carrier;
- the travel speed of the carrier and of the 1st and also further layer composites in steps i) and also iv) is between 0.1 and 1000 m/min;
- the dynamic viscosity at 25°C of the silicone composition (X), measured according to DIN 53019, is between 100 mPa•s and 1000 Pa•s;
- the surfaces of the carrier contain no depressions or elevations which are larger than 5% of the film thicknesses to be produced, and
- particles which are greater than 1/3 of the individual silicone layer thickness are removed from the crosslinkable silicone composition (X) before it is used.

2. Multilayer silicone composites produced by the method according to Claim 1, where each of the individual silicone layers has layer thicknesses of 0.1 to 200 µm, and a thickness precision of ± 3% as measured over an area of 200 cm².

3. Use of the multilayer silicone composites according to Claim 2 as dielectric electroactive polymers (EAP) in actuators, sensors or generators.

4. Use of the multilayer silicone composites according to Claim 2 as barrier films in the medical or food sector, insulating tapes, protective films, packaging material, wound contact materials, functional layers in clothing, substance separation or gas separation layer, cooking film, kitchen film, films for display applications, airbags or wine corks.

## Revendications

1. Procédé pour la fabrication de composites multicouches à base de silicone, dans lesquels au moins deux couches sont constituées par de la silicone durcie, présentant à chaque fois une épaisseur de couche de 0,1 à 200 µm, chacune parmi les différentes couches de silicone présentant une précision d'épaisseur de ± 5%, mesurée sur une surface de 200 cm², **caractérisé en ce que**
i) une composition (X) de silicone réticulable, contenant du solvant ou sans solvant, est appliquée à travers la fente d'une filière plate sur un support en mouvement,
ii) ensuite, le solvant, s'il est présent, est éliminé de la couche de silicone qui se forme sur la feuille support et la couche de silicone est partiellement réticulée de manière telle qu'elle présente un degré de réticulation d'au moins 40% et d'au plus 90%,
iii) des couches intermédiaires sont le cas échéant appliquées, de manière telle qu'il se forme un premier composite à couches, constitué par un support, une couche de silicone réticulée ainsi que le cas échéant par des couches intermédiaires,
iv) une composition (X) de silicone réticulable, contenant du solvant ou sans solvant, est appliquée à travers la fente d'une filière plate sur le premier composite à couches en mouvement,
v) ensuite, le solvant, s'il est présent, est éliminé de la couche de silicone qui se forme sur le premier composite à couches et la couche de silicone est partiellement réticulée de manière telle qu'elle présente un degré de réticulation d'au moins 40% et d'au plus 90%,
vi) les étapes iii) à v) sont le cas échéant répétées encore au moins 1 fois,
vii) une réticulation finale des couches de silicone est réalisée, car seule une réticulation partielle a eu lieu dans les étapes ii) et v),
viii)le composite multicouche de silicone formé peut ensuite être séparé du support,
dans les conditions suivantes :
- la filière plate dans les étapes i) et iv) se trouve sous un angle entre 10 ° et 90 ° par rapport au support ;
- la vitesse d'avancement du support ou du premier ainsi que des autres composites à couches dans les étapes i) et iv) se situe entre 0,1 et 1000 m/min ;
- la viscosité dynamique à 25°C, mesurée selon la norme DIN 53019, de la composition (X) de silicone se situe entre 100 mPa.s et 1000 Pa.s ;
- les surfaces du support ne contiennent pas de creux ni d'élévations qui sont supérieurs à 5% des épaisseurs de feuille à fabriquer et
- les particules qui sont plus grosses que 1/3 de chaque épaisseur de couche de silicone sont éliminées de la composition (X) de silicone réticulable avant son utilisation.

2. Composites multicouches à base de silicone fabriqués par le procédé selon la revendication 1, chacune des différentes couches de silicone présentant des épaisseurs de couche de 0,1 à 200 µm et une précision d'épaisseur de ± 3%, mesurée sur une surface de 200 cm².

3. Utilisation des composites multicouches à base de silicone selon la revendication 2 comme polymères électro-actifs (PEA) diélectriques dans des actionneurs, des capteurs ou des générateurs.

4. Utilisation des composites multicouches à base de silicone selon la revendication 2 comme feuilles formant une barrière dans le domaine médical ou alimentaire, comme bandes d'isolation, feuilles de protection, matériau d'emballage, recouvrements de plaie, couches fonctionnelles dans les vêtements, couches de séparation de substances ou de gaz, feuille de cuisson, feuille pour papillote, feuilles pour des utilisations d'affichage, airbags ou bouchons pour bouteilles de vin.
